(19) Europäisches Patentamt
European Patent Office
Office européen des brevets

(11) **EP 3 809 287 B1**

(12) **FASCICULE DE BREVET EUROPEEN**

(45) Date de publication et mention
de la délivrance du brevet:
**08.11.2023 Bulletin 2023/45**

(21) Numéro de dépôt: **20202104.4**

(22) Date de dépôt: **15.10.2020**

(51) Classification Internationale des Brevets (IPC):
**G06F 17/14** *(2006.01)*     **H03H 17/02** *(2006.01)*
**G01S 7/288** *(2006.01)*

(52) Classification Coopérative des Brevets (CPC):
**G06F 17/141; G01S 7/288; G01S 7/2883;**
**H03H 17/0213; H03H 17/0238; H03H 17/0264;**
G01S 7/2886; H03H 2017/0247

(54) **PROCÉDÉ DE SIMPLIFICATION D'UN FILTRE ET DISPOSITIFS ASSOCIÉS**

VERFAHREN ZUR VEREINFACHUNG EINES FILTERS UND ENTSPRECHENDE VORRICHTUNGEN

METHOD FOR SIMPLIFYING A FILTER AND ASSOCIATED DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2019 FR 1911522**

(43) Date de publication de la demande:
**21.04.2021 Bulletin 2021/16**

(73) Titulaire: **THALES**
**92400 Courbevoie (FR)**

(72) Inventeur: **HODE, Jean-Michel**
**33700 Merignac (FR)**

(74) Mandataire: **Lavoix**
**2, place d'Estienne d'Orves**
**75441 Paris Cedex 09 (FR)**

(56) Documents cités:
**WO-A2-2007/100666**    **FR-A1- 3 049 131**

• **SERBES A ET AL: "Efficient computation of DFT commuting matrices by a closed-form infinite order approximation to the second differentiation matrix", SIGNAL PROCESSING, ELSEVIER SCIENCE PUBLISHERS B.V. AMSTERDAM, NL, vol. 91, no. 3, mars 2011 (2011-03), pages 582-589, XP027449698, ISSN: 0165-1684, DOI: 10.1016/J.SIGPRO.2010.05.002 [extrait le 2010-10-28]**

EP 3 809 287 B1

**Description**

La présente invention concerne un procédé de simplification d'un filtre. La présente invention se rapporte également à un filtre, une chaîne de traitement et un radar associés.

Pour de multiples applications dans le domaine des radars, il est souhaitable de filtrer un signal numérisé avec une fonction de transfert spécifique.

Pour cela, il est utilisé des filtres de type transversal à réponse impulsionnelle finie. De tels filtres sont souvent désignés par l'acronyme FIR renvoyant à la terminologie anglo-saxonne « Finite Impulse Response » qui signifie « réponse impulsionnelle finie ». Les filtres FIR mettent en oeuvre des opérations comprenant l'utilisation de décalages temporels du signal, de gains et de sommations. Le nombre d'opérations est égal à la longueur de la réponse impulsionnelle du filtre FIR considérée (la longueur étant exprimée en nombre d'échantillons).

Cependant, lorsque la longueur de la réponse impulsionnelle du filtre est très grande, comme c'est le cas pour la compression d'impulsion mises en jeu dans les radars, la réalisation du filtrage devient problématique voire impossible compte-tenu du très grand nombre d'opérations impliquées.

Pour contourner un tel problème, il est connu d'effectuer certaine opération dans l'espace des fréquences. Pour cela, une transformation de Fourier est appliquée pour passer du domaine des temps au domaine des fréquences, l'opération de filtrage devenant alors multiplicative, puis une transformation de Fourier est appliquée ensuite pour revenir dans le domaine des temps.

En pratique, le temps est découpé en séquences et la transformation de Fourier est mise en oeuvre par une transformée de Fourier rapide souvent désignée par l'acronyme FFT pour « Fast Fourier Transform » (transformée de Fourier rapide en français). Plus précisément, le passage du domaine de l'espace des temps à l'espace des fréquences est obtenu par emploi d'une FFT alors que le passage du domaine de l'espace des fréquences à l'espace des temps est obtenu par l'emploi d'une IFFT. L'acronyme IFFT renvoie à « inverse Fast Fourier Transform » (transformée de Fourier rapide inverse en français).

L'emploi de transformées de Fourier rapide inverse ou non implique une taille au moins égale à la longueur du filtre. De fait, si la taille de la transformée de Fourier rapide inverse ou non est strictement égale à la taille K du filtre, alors le processus ne permet d'obtenir qu'un seul point sur K, les K-1 autres points calculés n'étant pas utilisables. Si la taille de la transformée de Fourier rapide inverse ou non est strictement égale à deux fois la taille K du filtre, soit 2K, alors le processus permet d'obtenir K points sur 2K, les K autres points calculés n'étant pas utilisables. Ainsi, en dédoublant le processus, il est possible de calculer 2 fois K points sur 2K et d'accéder à la totalité des points requis.

Toutefois, cela montre que la moitié des points calculés est perdue, ce qui augmente la charge de calcul et complique la mise en oeuvre du filtre.

Il existe donc un besoin pour un procédé de filtrage d'un signal d'entrée numérique qui soit de mise en oeuvre plus aisée.

Pour cela, il est décrit un procédé de filtrage d'un signal d'entrée numérique échantillonné à une fréquence d'échantillonnage pour obtenir un signal filtré, le procédé comportant au moins une étape de fourniture d'un signal d'entrée, une étape de transmission du signal d'entrée sur deux voies de traitement, une étape d'obtention d'un premier signal de sortie par la mise en oeuvre de premières opérations sur la première voie de traitement, les premières opérations comportant au moins l'application d'une transformée de Fourier discrète à $M/2^p$ points sur un signal issu du signal d'entrée, l'entier p étant supérieur ou égal à 1, une étape d'obtention d'un deuxième signal de sortie par la mise en oeuvre de deuxièmes opérations sur la deuxième voie de traitement, les deuxièmes opérations comportant au moins l'application d'un décalage de M/2 points à un signal issu du signal d'entrée puis l'application d'une transformée de Fourier discrète à $M/2^p$ points sur le signal décalé et une étape d'application d'une transformée de Fourier inverse discrète à $M/2^p$ points sur le premier signal pour obtenir M points de spectre du premier signal, M étant un nombre entier strictement supérieur à 2, l'étape d'application étant mise en oeuvre par l'addition des résultats de deux voies de traitement.

Il est également décrit un procédé de filtrage d'un signal d'entrée numérique échantillonné à une fréquence d'échantillonnage pour obtenir un signal filtré, le procédé comportant au moins une étape de fourniture d'un signal d'entrée, une étape de transmission du signal d'entrée sur deux voies de traitement, une étape d'obtention d'un premier signal de sortie par la mise en oeuvre de premières opérations sur la première voie de traitement, les premières opérations comportant au moins l'application d'un filtrage impliquant une transformée de Fourier discrète à M/2 points sur un signal issu du signal d'entrée, le filtrage présentant une latence de M, une étape d'obtention d'un deuxième signal de sortie par la mise en oeuvre de deuxièmes opérations sur la deuxième voie de traitement, les deuxièmes opérations comportant au moins l'application d'un décalage de M/2 points à un signal issu du signal d'entrée puis l'application d'un filtrage impliquant une transformée de Fourier discrète à M/2 points sur le signal décalé, le filtrage présentant une latence de M, une étape d'application d'une transformée de Fourier discrète inverse à M/2 points sur le premier signal pour obtenir M points de spectre du premier signal, M étant un nombre entier strictement supérieur à 2, et une étape de recombinaison des résultats de deux voies de traitement.

Suivant des modes de réalisation particuliers, le procédé de filtrage comprend une ou plusieurs des caractéristiques suivantes, prise(s) isolément ou suivant toutes les combinaisons techniquement possibles :

- le procédé comporte une mise en oeuvre au moins de l'étape d'application pour une pluralité de valeurs de p.
- l'entier p est inférieur ou égal l'entier $p_0$, l'entier $p_0$ étant un entier vérifiant $M/2^{p_0} = 1$.
- l'entier p augmente par incrément de 1.
- les premières opérations comportent un premier traitement du signal d'entrée pour obtenir un signal traité, une opération de mise en en oeuvre de l'étape d'application d'une transformée de Fourier discrète à M points sur le premier signal du procédé de filtrage tel que précédemment décrit, le premier signal étant le signal traité, chaque point de spectre du signal traité correspondant aux indices pairs d'une analyse spectrale à 2*M points du signal traité et étant repéré de manière bijective par un indice k, k étant un nombre pair compris entre 0 et 2*M-1, un deuxième traitement des points de spectre du signal traité pour obtenir des premiers points sélectionnés, une application de la transformée de Fourier discrète inverse à M points sur les premiers points sélectionnés pour obtenir un premier signal, et un troisième traitement du premier signal pour obtenir un premier signal de sortie.
- les deuxièmes opérations comportent un premier traitement du signal d'entrée pour obtenir un signal traité, une opération de mise en en oeuvre de l'étape d'application d'une transformée de Fourier discrète à M points sur le premier signal du procédé de filtrage tel que précédemment décrit, le premier signal étant le signal traité, chaque point de spectre du signal traité correspondant aux indices impairs d'une analyse spectrale à 2*M points du signal traité et étant repéré de manière bijective par un indice k, k étant un nombre pair compris entre 0 et 2*M-1, un deuxième traitement des points de spectre du signal traité pour obtenir des premiers points sélectionnés, une application de la transformée de Fourier discrète inverse à M points sur les premiers points sélectionnés pour obtenir un deuxième signal, et un troisième traitement du deuxième signal pour obtenir un deuxième signal de sortie.
- le procédé comporte une opération d'addition d'un signal d'entrée et du signal d'entrée décalé de N/2 points, le signal obtenu après addition étant le signal d'entrée de la première voie de traitement.
- le procédé comporte une opération d'addition d'un signal d'entrée et du signal d'entrée décalé de N points, le signal obtenu après addition étant le signal d'entrée de la deuxième voie de traitement.
- l'opération de décalage de N points est appliquée à l'aide de deux sous-unités.
- les premières opérations comportent un premier traitement du signal d'entrée pour obtenir un signal traité, une opération de mise en en oeuvre de l'étape d'application d'une transformée de Fourier discrète à M points sur le premier signal du procédé de filtrage tel que précédemment décrit, le premier signal étant le signal traité, chaque point de spectre du signal traité correspondant aux indices pairs d'une analyse spectrale à 2*M points du signal traité et étant repéré de manière bijective par un indice k, k étant un nombre pair compris entre 0 et 2*M-1, un deuxième traitement des points de spectre du signal traité pour obtenir des premiers points sélectionnés, une application de la transformée de Fourier discrète inverse à M points sur les premiers points sélectionnés pour obtenir un premier signal, et un troisième traitement du premier signal pour obtenir un premier signal de sortie.
- les deuxièmes opérations comportent un premier traitement du signal d'entrée pour obtenir un signal traité, une opération de mise en en oeuvre de l'étape d'application d'une transformée de Fourier discrète à M points sur le premier signal du procédé de filtrage tel que précédemment décrit, le premier signal étant le signal traité, chaque point de spectre du signal traité correspondant aux indices impairs d'une analyse spectrale à 2*M points du signal traité et étant repéré de manière bijective par un indice k, k étant un nombre pair compris entre 0 et 2*M-1, un deuxième traitement des points de spectre du signal traité pour obtenir des premiers points sélectionnés, une application de la transformée de Fourier discrète inverse à M points sur les premiers points sélectionnés pour obtenir un deuxième signal, et un troisième traitement du deuxième signal pour obtenir un deuxième signal de sortie.
- le procédé comprend la fourniture d'un signal d'entrée, la transmission du signal d'entrée sur deux voies, l'obtention d'un premier signal de sortie par la mise en oeuvre des premières opérations suivantes sur la première voie et l'obtention d'un deuxième signal de sortie par la mise en oeuvre des deuxièmes opérations suivantes sur la deuxième voie. L'obtention d'un premier signal de sortie par la mise en oeuvre des premières opérations suivantes sur la première voie : une première opération de premier traitement du signal d'entrée pour obtenir un signal traité, une première opération d'application d'une transformée de Fourier discrète à M points sur le signal traité pour obtenir M points de spectre du signal traité, M étant un nombre entier strictement supérieur à 2, chaque point de spectre du signal traité correspondant aux indices pairs d'une analyse spectrale à 2*M points du signal traité et étant repéré de manière bijective par un indice k, k étant un nombre pair compris entre 0 et 2*M-1, une première opération de deuxième traitement des points de spectre du signal traité pour obtenir des premiers points sélectionnés, une première opération d'application de la transformée de Fourier discrète inverse à M points sur les premiers points sélectionnés pour obtenir un premier signal et une première opération de troisième traitement du premier signal pour obtenir un premier signal de sortie. L'obtention d'un deuxième signal de sortie par la mise en oeuvre des deuxièmes opérations suivantes sur la deuxième voie : une deuxième opération de premier traitement du signal d'entrée pour obtenir un signal traité, une deuxième opération d'application d'une transformée de Fourier discrète à M points sur le signal traité pour obtenir M points de spectre du signal traité, M étant un nombre entier strictement supérieur à 2, chaque point de spectre du signal traité correspondant aux indices impairs d'une analyse spectrale à 2*M points du signal traités et étant repéré de manière bijective par un indice k, k étant un nombre impair compris entre 0 et 2*M-1, une deuxième opération de deuxième traitement des points de spectre du signal traité pour obtenir des deuxièmes points sélectionnés, une deuxième opération d'application de la transformée de Fourier discrète inverse à M points sur les deuxièmes points sélectionnés pour obtenir un deuxième signal et une deuxième opération de troisième traitement du deuxième signal pour obtenir un deuxième signal de sortie. Le procédé comporte également la recombinaison du premier signal de sortie et du deuxième signal de sortie pour obtenir le signal filtré.

- la deuxième opération de premier traitement comprend la mise en oeuvre d'une translation fréquentielle d'une valeur égale au ratio entre la fréquence d'échantillonnage et le nombre 2*M, et la deuxième opération de troisième traitement comprend la mise en oeuvre d'une translation fréquentielle appliquée au deuxième signal d'une valeur égale à l'opposé du ratio entre la fréquence d'échantillonnage et le nombre 2*M.
- la première opération de deuxième traitement comprend la mise en oeuvre du décalage des points de spectre du signal traité de M échantillons pour obtenir des points décalés et le calcul de la somme des points de spectre du signal traité et des points décalés, et la deuxième opération de deuxième traitement comprend la mise en oeuvre du décalage des points de spectre du signal traité de M échantillons pour obtenir des points décalés et le calcul de la somme des points de spectre du signal traité et des points décalés.

- la première opération de premier traitement comprend la mise en oeuvre du décalage du signal d'entrée de M échantillons pour obtenir un signal décalé et le calcul de la somme du signal d'entrée et du signal décalé, et la deuxième opération de premier traitement comprend la mise en oeuvre du décalage du signal d'entrée de M échantillons pour obtenir un signal décalé et le calcul de la différence entre le signal d'entrée et le signal décalé.
- l'étape de recombinaison est mise en oeuvre par calcul de la différence entre le premier signal de sortie et le deuxième signal de sortie.
- l'étape de recombinaison est mise en oeuvre par calcul de la différence entre le premier signal de sortie et le deuxième signal de sortie, pour obtenir un premier signal de calcul, calcul de la somme du premier signal de sortie et du deuxième signal de sortie, pour obtenir un deuxième signal intermédiaire de calcul, - décalage du deuxième signal intermédiaire de calcul de M échantillons pour obtenir un deuxième signal de calcul, et calcul de la somme du premier signal de calcul et du deuxième signal de calcul pour obtenir le signal filtré.

Il est également décrit un filtre propre à mettre en oeuvre le procédé de filtrage tel que précédemment décrit.

Il est aussi décrit un filtre propre à filtrer un signal d'entrée numérique échantillonné à une fréquence d'échantillonnage pour obtenir un signal filtré, le filtre comprenant une borne d'entrée propre à recevoir un signal d'entrée, une première voie de traitement propre à obtenir un premier signal de sortie par la mise en oeuvre de premières opérations, une deuxième voie de traitement propre à obtenir un deuxième signal de sortie par la mise en oeuvre de deuxièmes opérations, un transmetteur propre à transmettre le signal d'entrée sur la première voie de traitement et la deuxième voie de traitement, un mélangeur propre à recombiner le premier signal de sortie et le deuxième signal de sortie pour obtenir le signal filtré. La première voie de traitement est propre à mettre en oeuvre les premières opérations suivantes : premier traitement du signal d'entrée pour obtenir un signal traité, application d'une transformée de Fourier discrète à M points sur le signal traité pour obtenir M points de spectre du signal traité, M étant un nombre entier strictement supérieur à 2, chaque point de spectre du signal traité correspondant aux indices pairs d'une analyse spectrale à 2*M points du signal traité et étant repéré de manière bijective par un indice k, k étant un nombre pair compris entre 0 et 2*M-1, l'application étant mise en oeuvre par addition des résultats de deux voies de traitement, la première voie de calcul appliquant une transformée de Fourier discrète à M/2 points au signal traité et la deuxième voie de calcul appliquant un décalage de M/2 points au signal traité puis appliquant une transformée de Fourier discrète à M/2 points au premier signal, deuxième traitement des points de spectre du signal traité pour obtenir des premiers points sélectionnés, application de la transformée de Fourier discrète inverse à M points sur les premiers points sélectionnés pour obtenir un premier signal, et troisième traitement du premier signal pour obtenir un premier signal de sortie. La deuxième voie de traitement est propre à mettre en oeuvre les deuxièmes opérations suivantes : premier traitement du signal d'entrée pour obtenir un signal traité, application d'une transformée de Fourier discrète à M points sur le signal traité pour obtenir M points de spectre du signal traité, M étant un nombre entier strictement supérieur à 2, chaque point de spectre du signal traité correspondant aux indices impairs d'une analyse spectrale à 2*M points du signal traité et étant repéré de manière bijective par un indice k, k étant un nombre impair compris entre 0 et 2*M-1, l'application étant mise en oeuvre par addition des résultats de deux voies de traitement, la première voie de calcul appliquant une transformée de Fourier discrète à M/2 points au signal traité et la deuxième voie de calcul appliquant un décalage de M/2 points au signal traité puis appliquant une transformée de Fourier discrète à M/2 points au premier signal, deuxième traitement des points de spectre du signal traité pour obtenir des deuxièmes points sélectionnés, application de la transformée de Fourier discrète inverse à M points sur les deuxièmes points sélectionnés pour obtenir un deuxième signal, et troisième traitement du deuxième signal pour obtenir un deuxième signal de sortie.

Suivant des modes de réalisation particuliers, le filtre comprend une ou plusieurs des caractéristiques suivantes, prise(s) isolément ou suivant toutes les combinaisons techniquement possibles :

- le filtre est propre à filtrer un signal d'entrée numérique échantillonné à une fréquence d'échantillonnage pour obtenir un signal filtré, le filtre comprenant une borne d'entrée propre à recevoir un signal d'entrée, une première voie propre à obtenir un premier signal de sortie par la mise en oeuvre de premières opérations, une deuxième voie propre à obtenir un deuxième signal de sortie par la mise en oeuvre de deuxièmes opérations, un transmetteur propre à transmettre le signal d'entrée sur la première voie et la deuxième voie, un mélangeur propre à recombiner le premier signal de sortie et le deuxième signal de sortie pour obtenir le signal filtré, la première voie étant propre à mettre en oeuvre les premières opérations suivantes : une première opération de premier traitement du signal d'entrée pour obtenir un signal traité, une première opération d'application d'une transformée de Fourier discrète à M points sur le signal traité pour obtenir M points de spectre du signal traité, M étant un nombre entier strictement supérieur à 2, chaque point de spectre du signal traité correspondant aux indices pairs d'une analyse spectrale à 2*M points du signal traité et étant repéré de manière bijective par un indice k, k étant un nombre pair compris entre 0 et 2*M-1, une première opération de deuxième traitement des points de spectre du signal traité pour obtenir des premiers points sélectionnés, une première opération d'application de la transformée de Fourier discrète inverse à M points sur les premiers points sélectionnés pour obtenir un premier signal et une première opération de troisième traitement du premier signal pour obtenir un premier signal de sortie. La deuxième voie est propre à mettre en oeuvre les deuxièmes opérations suivantes : une deuxième opération de premier traitement du signal d'entrée pour obtenir un signal traité, une deuxième opération d'application d'une transformée de Fourier discrète à M points sur le signal traité pour obtenir M points de spectre du signal traité, M étant un nombre entier strictement supérieur à 2, chaque point de spectre du signal traité correspondant aux indices impairs d'une analyse spectrale à 2*M points du signal traité et étant repéré de manière bijective par un indice k, k étant un nombre impair compris entre 0 et 2*M-1, une deuxième opération de deuxième traitement des points de spectre du signal traité pour obtenir des deuxièmes points sélectionnés, une deuxième opération d'application de la transformée de Fourier discrète inverse à M points sur les deuxièmes points sélectionnés pour obtenir un deuxième signal et une deuxième opération de troisième traitement du deuxième signal pour obtenir un deuxième signal de sortie.

Il est également proposé un procédé de simplification d'un filtre numérique de signal échantillonné, le procédé comportant au moins une étape de fourniture d'un filtre comprenant des premières voies propres à obtenir un premier signal de sortie par mise en oeuvre de premières opérations, et des deuxièmes voies propres à obtenir un deuxième signal de sortie par mise en oeuvre de deuxièmes opérations, et une unité de recombinaison des signaux obtenus en sortie des premières voies et des deuxièmes voies, les premières opérations et les deuxièmes opérations comportant au moins une succession d'opérations non-stationnaires discrètes et d'opérations stationnaires, la succession portant sur des opérations communes aux premières et deuxièmes opérations, et une étape de, pour obtenir un premier filtre intermédiaire, rassemblement des voies comportant des opérations non-stationnaires discrètes portant sur le même signal, les premières voies comportant les opérations non-stationnaires portant sur un premier signal et les deuxièmes voies comportant les opérations non-stationnaires portant sur un deuxième signal, une étape de, pour obtenir un deuxième filtre intermédiaire, sur chacune des premières voies et deuxièmes voies, commutation des opérations stationnaires avec les opérations non-stationnaires, pour éliminer les opérations non-stationnaires redondantes, et une étape de construction du filtre correspondant au dernier filtre intermédiaire obtenu.

Suivant des modes de réalisation particuliers, le procédé de simplification comprend une ou plusieurs des caractéristiques suivantes, prise(s) isolément ou suivant toutes les combinaisons techniquement possibles :

- les opérations non-stationnaires comportent deux opérations réciproques l'une de l'autre.
- les deux signaux de l'étape de rassemblement forment un signal complet.
- le nombre de points de chaque signal est identique.
- les opérations non-stationnaires sont choisies dans un groupe constitué des transformées de Fourier discrètes, des transformées de Fourier inverse discrètes et des translations de fréquence.
- les opérations stationnaires sont des opérations discrètes dans un groupe constitué d'un filtrage réalisé de manière multiplicative en fréquence, une sommation, un retard et une différence.
- le filtre numérique de signal échantillonné à simplifier est un filtre tel que précédemment décrit ou implémentant un procédé de filtrage tel que précédemment décrit.

La description concerne aussi une chaîne de traitement comprenant au moins un filtre tel que précédemment décrit.

Suivant des modes de réalisation particuliers, la chaîne de traitement comprend une ou plusieurs des caractéristiques suivantes, prise(s) isolément ou suivant toutes les combinaisons techniquement possibles :

- la chaîne de traitement est un circuit logique programmable.
- la chaîne de traitement est un circuit intégré propre à une application.
- la chaîne de traitement est réalisée sous forme d'un circuit logique programmable.
- la chaîne de traitement est réalisée sous forme d'un circuit intégré propre à une application.

De plus, il est également décrit un système comportant une chaîne de traitement telle que précédemment décrite.

D'autres caractéristiques et avantages de l'invention apparaîtront à la lecture de la description qui suit de modes de réalisation de l'invention, donnée à titre d'exemple uniquement et en référence aux dessins qui sont :

- figure 1, une vue schématique d'un exemple de radar comprenant plusieurs filtres,
- figure 2, un schéma-bloc montrant les opérations effectuées par un premier exemple de filtre,
- figure 3, un schéma-bloc montrant les opérations effectuées par un deuxième exemple de filtre,
- figure 4, un schéma-bloc montrant les opérations effectuées par un troisième exemple de filtre,
- figure 5, un schéma-bloc montrant les opérations effectuées par un quatrième exemple de filtre,
- figure 6, un schéma-bloc montrant les opérations effectuées par un cinquième exemple de filtre,
- figure 7, un schéma-bloc montrant les opérations effectuées par un sixième exemple de filtre,
- figure 8, un schéma-bloc montrant les opérations effectuées par un septième exemple de filtre,
- figure 9, un schéma-bloc illustrant le bon fonctionnement du filtre de la figure 8,
- figure 10, un schéma-bloc illustrant un circuit de base utilisé pour obtenir l'architecture du filtre de la figure 2,
- figure 11, un schéma-bloc montrant les opérations effectuées par un huitième exemple de filtre,
- figure 12, un schéma-bloc montrant un circuit propre à réaliser une partie des opérations du huitième exemple de filtre,
- figure 13, un schéma-bloc montrant les opérations effectuées par un neuvième exemple de filtre, et
- figure 14, un schéma-bloc montrant un circuit propre à réaliser une partie des opérations du neuvième exemple de filtre.

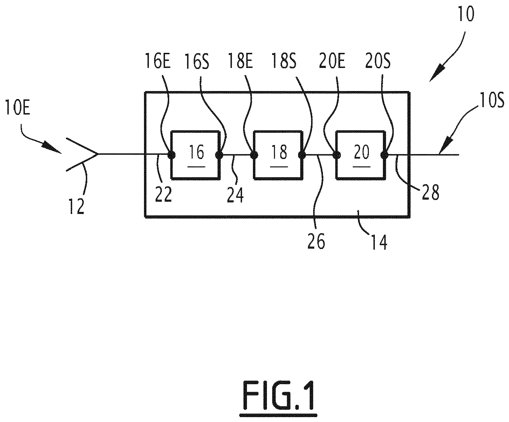

Un système 10 est schématiquement illustré à la figure 1.

Le système 10 est, par exemple, un radar 10.

En variante, le système 10 est un système de communication, un système de contre-mesures ou un système de détection tel un goniomètre.

Le radar 10 est propre à recevoir un signal d'entrée 10E et à convertir le signal d'entrée 10E en un signal de sortie 10S exploitable pour des utilisations ultérieures.

Le radar 10 comporte une antenne 12 et une chaîne de traitement 14.

L'antenne 12 est propre à recevoir le signal d'entrée 10E.

La chaîne de traitement 14 est propre à assurer la conversion du signal d'entrée 10E en signal de sortie 10S.

La chaîne de traitement 14 est propre à réaliser un filtrage du signal d'entrée 10E.

Selon l'exemple de la figure 1, la chaîne de traitement 14 comporte trois filtres 16, 18 et 20 en série.

De fait, le premier filtre 16 comporte une borne d'entrée 16E reliée à l'antenne 12 par un premier fil 22 et une borne de sortie 16S reliée au deuxième filtre 18 par un deuxième fil 24.

Le deuxième filtre 18 comporte une borne d'entrée 18E reliée à la borne de sortie 16S du premier filtre 16 par le deuxième fil 24 et une borne de sortie 18S reliée au troisième filtre 20 par un troisième fil 26.

Le troisième filtre 20 comporte une entrée 20E reliée à la borne de sortie 18S du deuxième filtre 18 par le troisième fil 26 et une borne de sortie 20S reliée au quatrième fil 28 transmettant le signal de sortie 10S.

Selon un autre mode de réalisation, la chaîne de traitement 14 comporte un seul filtre.

En variante, la chaîne de traitement 14 comporte un nombre quelconque filtres, par exemple 2, 4 ou 6.

La chaîne de traitement 14 est, par exemple, un circuit logique programmable. Un tel circuit est souvent désigné sous l'acronyme FPGA, acronyme anglais de l'expression « field-programmable gate array », réseau de portes programmables in situ.

Selon un autre exemple, la chaîne de traitement 14 est un circuit intégré propre à une application. Un tel circuit est souvent désigné par l'acronyme ASIC (acronyme de l'anglais « application-specific integrated circuit », signifiant « circuit intégré propre à une application »).

Chaque filtre 16, 18 et 20 est propre à filtrer un signal d'entrée numérique échantillonné à une fréquence d'échantillonnage pour obtenir un signal filtré.

Pour simplifier la description, il est supposé que chacun des filtres 16, 18 et 20 est identique.

En variante, chaque filtre de la chaîne de traitement 14 est différent.

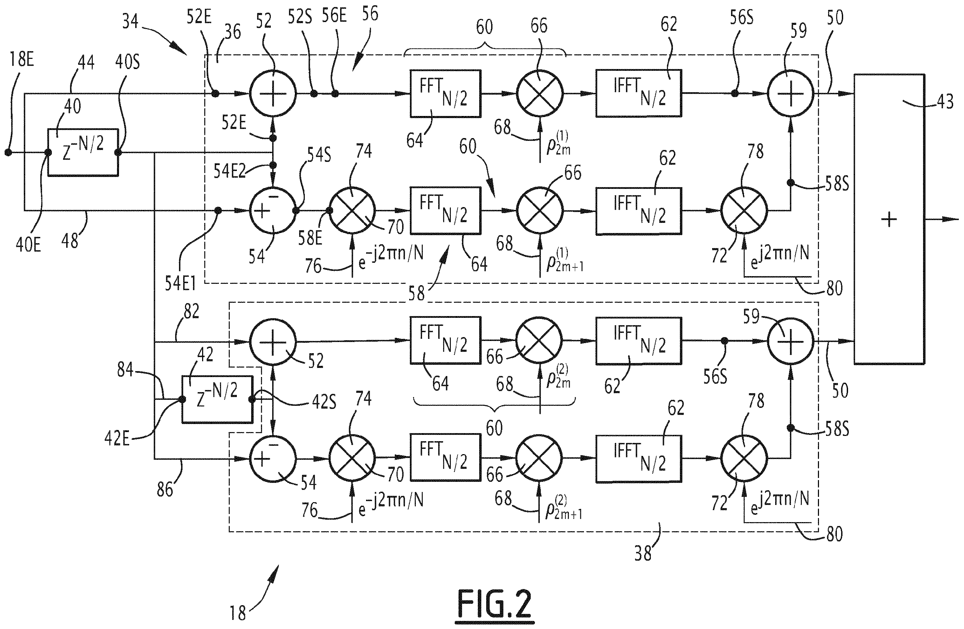

Un exemple de deuxième filtre 18 est illustré plus précisément sur la figure 2.

Le deuxième filtre 18 comporte deux blocs principaux 34 que sont le premier bloc principal 36 et le deuxième bloc principal 38, une première unité de calcul 40, une deuxième unité de calcul 42 et un additionneur de sortie 43.

Le premier bloc principal 36 et le deuxième bloc principal 38 sont identiques.

Par le terme « identique » dans ce contexte, il est entendu que chacun des deux blocs principaux 36 et 38 est propre à appliquer les mêmes opérations sur un signal incident.

Aussi, dans un souci de simplification, seul le premier bloc principal 36 est décrit dans ce qui suit.

Le premier bloc principal 36 comporte trois branches d'entrées 44, 46 et 48 et une branche de sortie 50.

Le premier bloc principal 36 comporte aussi un additionneur d'entrée 52, un soustracteur d'entrée 54, une première voie de traitement 56, une deuxième voie de traitement 58 et un additionneur de sortie 59.

La première branche 44 du premier bloc principal 36 est directement reliée à l'entrée 18E du filtre 18.

La deuxième branche 46 du premier bloc principal 36 est reliée à la première unité de calcul 40.

Plus précisément, la première unité de calcul 40 comporte une entrée 40E et une sortie 40S et la sortie 40S de la première unité de calcul 40 est reliée à la deuxième branche 46 du premier bloc principal 36.

L'entrée 40E de la première unité de calcul 40 est directement reliée à l'entrée 18E du filtre 18.

La première unité de calcul 40 est une unité de décalage.

Le décalage est illustré schématiquement sur la figure 2 par une boîte 40 dans laquelle il est inscrit « $z^{-N/2}$ » par référence à une technique de décalage par utilisation de la transformée en Z.

N est dans ce qui suit, un entier pair strictement supérieur à 4 de sorte que l'entier N/2 est supérieur ou égal à 2.

L'entier N correspondant au nombre d'échantillons, il est en général relativement grand, en particulier supérieur ou égal à 100.

La troisième branche 48 du premier bloc principal 36 est directement reliée à l'entrée 18E du filtre 18.

L'additionneur d'entrée 52 et le soustracteur d'entrée 54 interagissant avec les deux voies de traitements 56 et 58, il convient d'introduire maintenant que la première voie de traitement 56 s'étend entre une entrée 56E et une sortie 56S et que la deuxième voie de traitement 58 s'étend entre une entrée 58E et une sortie 58S.

L'additionneur d'entrée 52 comporte deux entrées 52E respectivement reliées à la première branche 44 du premier bloc principal 36 et à la deuxième branche 46 du premier bloc principal 36. L'additionneur d'entrée 52 comporte, également, une sortie 52S reliée à l'entrée 56E de la première voie de traitement 56.

L'additionneur d'entrée 52 est propre à mettre en oeuvre une opération d'addition appliquée au deux signaux de sortie de la première branche 44 et de la deuxième branche 46 du premier bloc principal 36, le signal obtenu après addition étant injecté à l'entrée 56E de la première voie de traitement 56.

D'un point de vue plus mathématique, l'additionneur d'entrée 52 est propre à effectuer l'addition entre un signal et le même signal décalé de N/2 points.

Le soustracteur d'entrée 54 comporte une première entrée 54E1 reliée à la troisième branche 48 du premier bloc principal 36 et une deuxième entrée 54E2 reliée à la deuxième branche 46 du premier bloc principal 36. Le soustracteur d'entrée 54 comporte, également, une sortie 54S reliée à l'entrée 58S de la deuxième voie de traitement 58.

Le soustracteur d'entrée 54 est propre à mettre en oeuvre une opération de différence appliquée entre les deux signaux d'entrée de la troisième branche 48 et de la deuxième branche 46 du premier bloc principal 36, le signal obtenu après soustraction étant injecté à l'entrée 58S de la deuxième voie de traitement 58.

D'un point de vue plus mathématique, le soustracteur d'entrée 54 est propre à effectuer la soustraction entre un signal et le même signal décalé de N/2 points.

La première voie de traitement 56 comporte successivement deux sous-unités : une première sous-unité 60 et une deuxième sous-unité 62.

En d'autres termes, les deux sous-unités 60 et 62 sont en série.

La première sous-unité 60 est propre à appliquer une transformée de Fourier discrète à N/2 points sur le signal précédemment obtenu (signal avant la première sous-unité 60), dit signal traité, pour obtenir N/2 points de spectre du signal traité, chaque point de spectre du signal traité correspondant aux indices pairs d'une analyse spectrale à 2*N/2=N points du signal traité et étant repéré de manière bijective par un indice k, k étant un nombre pair compris entre 0 et 2*M-1 (avec M=N/2). Dans ce cas, les points sont numérotés de 0 à 2*M-1.

Cela revient à calculer les coefficients pairs de l'analyse spectrale à N points du signal traité pour obtenir des points sélectionnés.

Par exemple, la transformée de Fourier discrète calculée est une transformée de Fourier rapide notée $FFT_{N/2}$.

Cela est illustré schématiquement sur la figure 2 par une boîte 64 dans laquelle il est inscrit $FFT_{N/2}$ et par un multiplieur 66 sur lequel arrive une flèche 68 avec l'inscription « $\rho^{(1)}_{2m}$ », le (1) faisant référence au fait qu'il s'agit de la première voie de traitement 56.

La deuxième sous-unité 62 est également propre à mettre en oeuvre une opération d'application de la transformée de Fourier discrète inverse à N/2 points sur les points sélectionnés.

Par exemple, la transformée de Fourier discrète calculée est une transformée de Fourier rapide notée $IFFT_{N/2}$.

Cela est illustré schématiquement sur la figure 2 par une boîte dans laquelle il est inscrit $IFFT_{N/2}$.

La deuxième sous-unité 62 présente une sortie reliée à l'additionneur de sortie 59.

La deuxième voie de traitement 58 comporte également une première sous-unité 60 et une deuxième sous-unité 62 ainsi que deux modules de décalages 70 et 72.

Comme indiqué précédemment, les deux sous-unités 60 et 62 de la deuxième voie de traitement 58 sont similaires aux deux sous-unités 60 et 62 de la première voie de traitement 56.

Le premier module de décalage 70 est situé entre l'entrée 58S de la deuxième voie de traitement 58 et la première sous-unité 60.

Le premier module de décalage 70 est propre à mettre en oeuvre une translation fréquentielle d'une valeur égale au ratio entre la fréquence d'échantillonnage et le nombre N.

Un tel premier module de décalage 70 est symbolisé par une flèche 74 sur un multiplieur 76, flèche 74 sur laquelle est inscrite « $e^{-2j\pi n/N}$ » par référence à une technique usuelle de translation qui consiste à multiplier le signal par une exponentielle complexe bien choisie.

Le deuxième module de décalage 72 est située entre la deuxième sous-unité 60 et la sortie 58S de la deuxième voie de traitement 58.

En l'occurrence, le deuxième module de décalage 72 est propre à mettre en oeuvre une translation fréquentielle d'une valeur opposée au ratio entre la fréquence d'échantillonnage et le nombre N.

Un tel deuxième module de décalage 72 est symbolisé par une flèche 78 sur un multiplieur 80, flèche 78 sur laquelle est inscrite « $e^{-2j\pi n/N}$ » par référence à une technique usuelle de translation qui consiste à multiplier le signal par une exponentielle complexe bien choisie.

L'additionneur de sortie 59 est relié respectivement au deux sorties 56S et 58S de chaque voie de traitement 56 et 58 et délivre en sortie la somme des deux sorties 56S et 58S de chaque voie de traitement 56 et 58.

La sortie 59S de l'additionneur de sortie 59 correspond à la branche de sortie 50 du premier bloc principal 36.

Comme indiqué précédemment, le deuxième bloc principal 38 comporte les mêmes éléments que le premier bloc principal 36. Seuls les signaux injectés en entrée diffère.

La première branche d'entrée 82 du deuxième bloc principal 38 est reliée à la deuxième branche d'entrée 46 du premier bloc principal 36.

Cela signifie que, dans la première branche d'entrée 82 du deuxième bloc principal 38, est injecté le signal d'entrée du filtre 18 décalé de N/2.

La deuxième branche d'entrée 84 du deuxième bloc principal 38 est reliée à une deuxième unité de calcul 42.

Plus précisément, la deuxième unité de calcul 42 comporte une entrée 42E et une sortie 42S et la sortie 42S de la deuxième unité de calcul 42 est reliée à la deuxième branche d'entrée 84 du deuxième bloc principal 38.

L'entrée 42E de la deuxième unité de calcul 42 est directement reliée à l'entrée 18E du filtre 18.

La deuxième unité de calcul 42 est une unité de décalage.

Le décalage est illustré schématiquement sur la figure 2 par une boîte 42 dans laquelle il est inscrit « $z^{-N/2}$ » par référence à une technique de décalage par utilisation de la transformée en Z.

Cela signifie que, dans la deuxième branche d'entrée 84 du deuxième bloc principal 42, est injecté le signal d'entrée du filtre 18 décalé de N.

La troisième branche d'entrée 86 du deuxième bloc principal 38 est directement reliée à la deuxième branche d'entrée 46 du premier bloc principal 36.

Cela signifie que, dans la troisième branche d'entrée 86 du deuxième bloc principal 38, est injecté le signal d'entrée du filtre 18 décalé de N/2.

Enfin, l'additionneur de sortie 43 est reliée à la branche de sortie de chaque bloc principal 36 et 38.

La sortie 18S du filtre 18, qui est reliée à la sortie de l'additionneur de sortie 59, est traversée par un signal correspondant à la somme des signaux circulant dans les branche de sortie de chaque bloc principal 36 et 38.

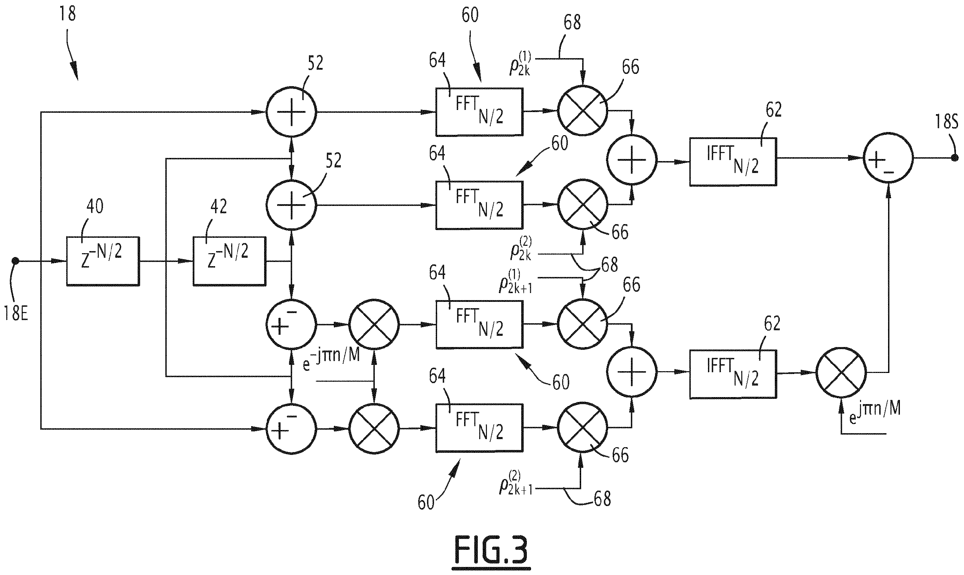

Une architecture améliorée pour le filtre 18 de la figure 2 est proposée à la figure 3.

L'architecture optimisée à la figure 3 exploite avantageusement la similitude entre d'une part les premières voies de traitements 56 des blocs principaux et d'autre part les deuxièmes voies de traitement 58 des blocs principaux. Par similitude dans un tel contexte, il est entendu des opérations ou des traitements similaires.

Plus précisément, dans le cas d'espèce, il est utilisé le fait que dans les premières voies de traitements 34, les opérations d'IFFT portent sur les points de spectre correspondent aux indices pairs alors que, dans les deuxièmes voies de traitements 34, les opérations d'IFFT portent sur les points de spectre correspondent aux indices impairs.

Selon l'architecture de la figure 3, les premières voies de traitements 34 sont mutualisées par un additionneur intermédiaire, ce qui permet d'utiliser une seule unité d'application de l'IFFT en sortie au lieu de deux dans le cas de la figure 2.

Similairement, les deuxièmes voies de traitements 34 sont mutualisées par un additionneur intermédiaire, ce qui permet d'utiliser une seule unité d'application de l'IFFT en sortie pour chacun deuxièmes voies de traitements 34 ainsi qu'une seule unité d'application de décalage au lieu de deux en sortie dans le cas de la figure 2.

L'additionneur final est remplacé par un soustracteur.

Le filtre 18 de la figure 3 est ainsi optimisée par rapport au filtre 18 de la figure 2 puisque le filtre 18 de la figure 3 implique trois opérations consommatrices de ressources, à savoir deux opérations d'IFFT et une opération de décalage.

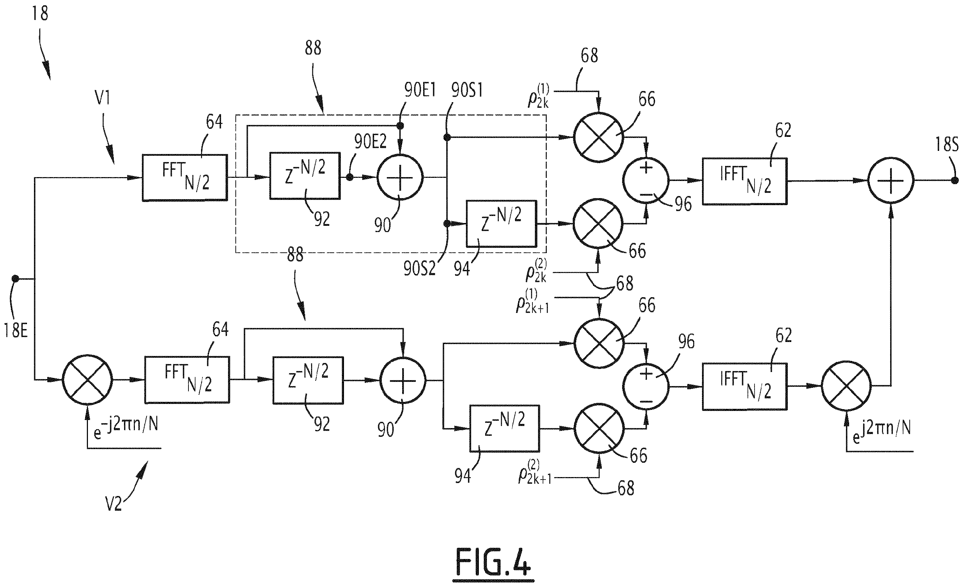

Une architecture encore améliorée pour le filtre 18 de la figure 2 et le filtre 18 de la figure 3 est proposée à la figure 4.

Comme pour le cas de la figure 3, l'architecture optimisée à la figure 4 exploite avantageusement la similitude entre d'une part les premières voies de traitements 56 des blocs principaux et d'autre part les deuxièmes voies de traitement 58 des blocs principaux.

Plus précisément, dans le cas d'espèce par comparaison avec le cas de la figure 3, il est utilisé le fait que l'opération FFT d'une première voie de traitement 56 diffère uniquement de l'opération FFT de l'autre première voie de traitement 56 par l'application de décalages sur les points sur lesquels l'opération de FFT considérée est appliquée. Similairement, l'opération FFT d'une deuxième voie de traitement 58 diffère uniquement de l'opération FFT de l'autre deuxième voie de traitement 58 par l'application de décalages sur les points sur lesquels l'opération de FFT considérée est appliquée.

Comme les décalages peuvent être mutualisés et appliqués après l'opération de FFT, l'architecture de la figure 4 est obtenue.

Le filtre de la figure 4 comporte ainsi deux voies de traitement V1 et V2 qui sont sommées en sortie par un additionneur final.

La deuxième voie V2 comporte la même succession d'opérations que les opérations de la première voie V1. La deuxième voie V2 diffère uniquement de la première voie V1 par la présence d'une unité de décalage en amont de la succession d'opérations et la présence d'une unité de décalage en sens inverse en aval de la succession d'opérations. Les opérations appliquées entre les deux unités de décalages qui sont les mêmes que les opérations de la première voie V1 sont maintenant décrites par la description de la première voie V1 qui suit.

La première voie V1 comporte successivement une unité $FFT_{N/2}$ 64, une unité de préparation du signal 88, deux unités de sélection 66, un additionneur 96 et une unité $IFFT_{N/2}$ 62.

L'unité $FFT_{N/2}$ 64 est propre à appliquer une FFT à N/2 points sur le signal issu de la borne d'entrée 18E du filtre 18.

L'unité de préparation du signal 88 sert à préparer le signal à envoyer pour chaque unité de sélection.

L'unité de préparation du signal 88 comporte uniquement des sous-unités d'addition 90 et des sous-unités de décalage 92 et 94.

Plus précisément, l'unité de préparation du signal 88 comporte une sous-unité d'addition et deux sous-unités de décalage.

La sous-unité d'addition 90 est propre à effectuer l'addition entre deux branches d'entrée, une première branche d'entrée correspondant au spectre obtenu en sortie de l'unité $FFT_{N/2}$ et une deuxième branche d'entrée comportant une sous-unité de décalage de N/2 représentée par une boîte $z^{-N/2}$. La deuxième branche d'entrée correspond ainsi au spectre obtenu en sortie de l'unité $FFT_{N/2}$ avec un décalage de N/2 points.

La sous-unité d'addition 90 comporte deux branches de sorties, une première branche de sortie reliée directement à la première unité de sélection et une deuxième branche de sortie comportant une sous-unité de décalage de N/2 représentée par une boîte $z^{-N/2}$, la sous-unité de décalage de la deuxième branche de sortie étant reliée à la deuxième unité de sélection.

Les unités de sélection 66 sont ensuite reliées à l'additionneur 96 dont la sortie est reliée à l'unité $IFFT_{N/2}$.

L'architecture de filtre 18 représentée à la figure 4 est ainsi optimisée par rapport au filtre 18 de la figure 3 par le fait que deux opérations de FFT très coûteuses en termes de ressources ne sont plus mises en oeuvre.

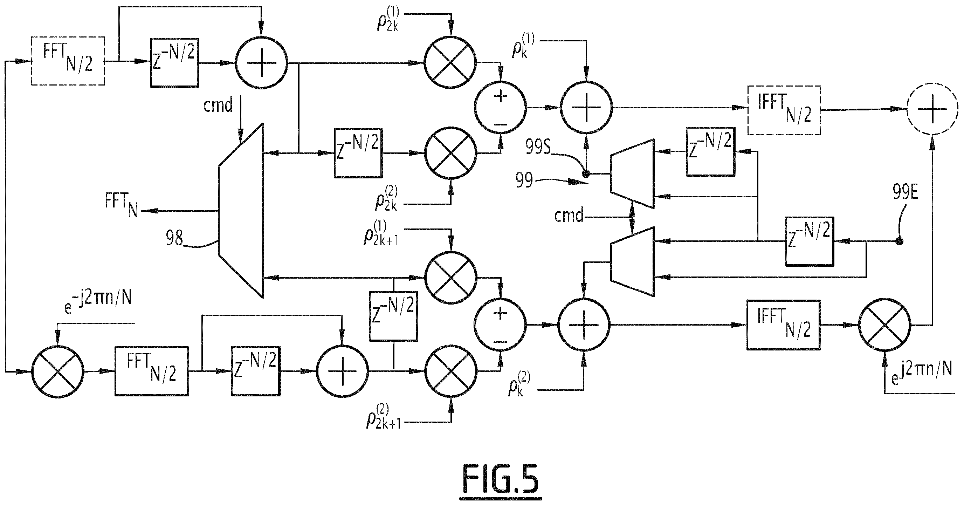

Ainsi que le montre la figure 5, il est également possible d'exploiter l'architecture de filtre 18 de la figure 4 pour introduire des extracteurs de calcul pour récupérer le résultat de ces opérations pourvu que ces résultats puissent être utilisés pour un autre calcul du filtre 18 ou d'un autre élément extérieur au filtre 18.

Selon l'exemple de la figure 5, le filtre 18 comporte les mêmes éléments que le filtre 18 de la figure 4 ainsi que deux extracteurs de calcul 98 et 99.

Le premier extracteur de calcul 98 sert à exporter le résultat de la FFT à N points vers l'extérieur du filtre 18.

Le deuxième extracteur de calcul 99 sert à mettre en oeuvre partiellement l'IFFT à N/2 points sur un signal injecté depuis l'extérieur dans l'additionneur situé directement en amont de l'unité d'application de l'IFFT.

De manière correspondante, comme représenté avec des lignes pointillées, le calcul de la $FFT_{N/2}$ peut être réalisé dans un autre filtre de sorte que la présence de l'unité de calcul de la $FFT_{N/2}$ est évitée.

L'architecture de filtre 18 proposée pour la figure 5 permet ainsi de mutualiser les ressources de calcul entre plusieurs étages ou dispositifs de calcul.

De tels principes de simplification correspondent de manière plus générale à un procédé de simplification d'un filtre numérique de signal échantillonné utilisant les propriétés précitées de commutation d'opérations stationnaires (décalage, sommation) et non-stationnaires discrètes (FFT et IFFT).

Un tel procédé de simplification comporte au moins une étape de fourniture S1, une étape de rassemblement S2, une étape de commutation S3 et une étape de construction S4.

Lors de l'étape de fourniture S1, il est fourni un filtre comprenant des premières voies propres à obtenir un premier signal de sortie par mise en oeuvre de premières opérations, des deuxièmes voies propres à obtenir un deuxième signal de sortie par mise en oeuvre de deuxièmes opérations, et une unité de recombinaison des signaux obtenus en sortie des premières voies et des deuxièmes voies.

Les premières opérations et les deuxièmes opérations comportant au moins la même succession d'opérations non-stationnaires discrètes et d'opérations stationnaires, la succession portant sur des opérations communes aux premières et deuxièmes opérations.

Lors de l'étape de rassemblement S2, pour obtenir un premier filtre intermédiaire, sont rassemblées des voies comportant des opérations non-stationnaires discrètes portant sur le même signal, les premières voies rassemblées comportant les opérations non-stationnaires portant sur un premier signal et les deuxièmes voies rassemblées comportant les opérations non-stationnaires portant sur un deuxième signal.

Lors de l'étape de commutation S3, pour obtenir un deuxième filtre intermédiaire, sur chacune des premières voies et deuxièmes voies, sont commutées des opérations stationnaires avec les opérations non-stationnaires, pour éliminer les opérations non-stationnaires redondantes.

Lors de l'étape de construction S4, il est construit le filtre correspondant au dernier filtre intermédiaire obtenu.

Un tel procédé de simplification permet d'obtenir des circuits de calcul impliquant moins de ressources calculatoires.

Autrement formulé, le procédé réalise une simplification en ce sens qu'est réalisées une économie des ressources.

Selon un exemple particulier, au moins une des opérations non-stationnaires et stationnaires est une opération discrète.

De préférence, les opérations non-stationnaires comportent deux opérations réciproques l'une de l'autre.

Selon un mode réalisation particulier, les deux signaux de l'étape de rassemblement forment un signal complet.

Avantageusement, le nombre de points de chaque signal est identique.

Selon un mode de réalisation, les opérations non-stationnaires sont choisies dans un groupe constitué des transformées de Fourier discrètes, des transformées de Fourier inverse discrètes et des translations de fréquence.

Dans un exemple particulier, les opérations stationnaires sont des opérations discrètes dans un groupe constitué d'un filtrage réalisé de manière multiplicative en fréquence, une sommation, un retard et une différence.

Comme expliqué précédemment, le procédé de simplification permet d'obtenir une pluralité de filtres 18 réalisant la même fonction avec plus ou moins de ressources impliquées.

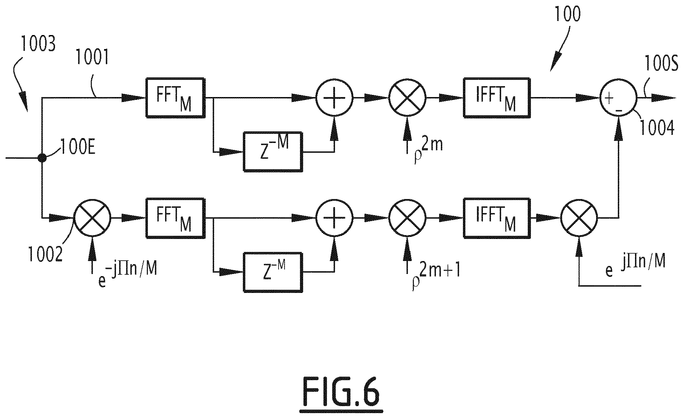

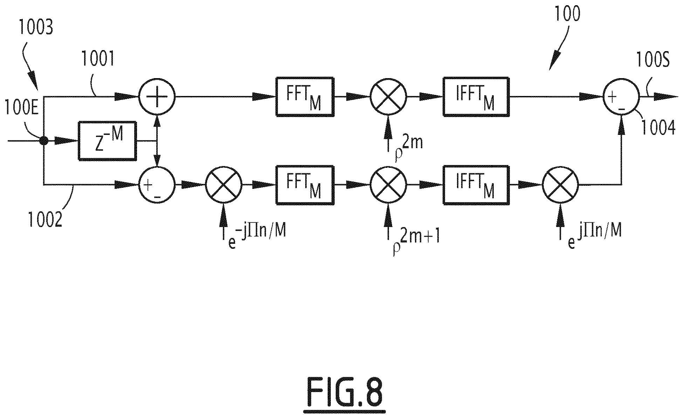

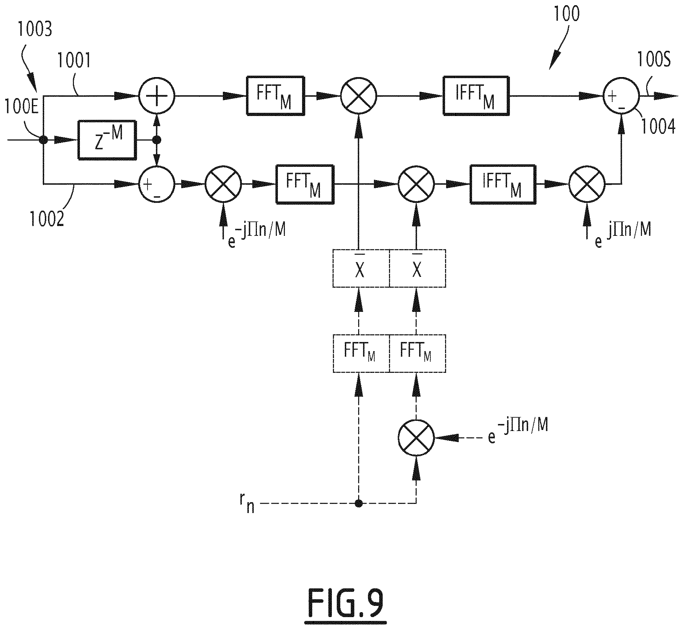

Chacune implémentation précitée du filtre 18 est à comparer aux filtres 100 des figures 6 à 8 ainsi qu'en référence à la figure 9 qui correspond à un schéma-bloc illustrant le bon fonctionnement du filtre 100 de la figure 8.

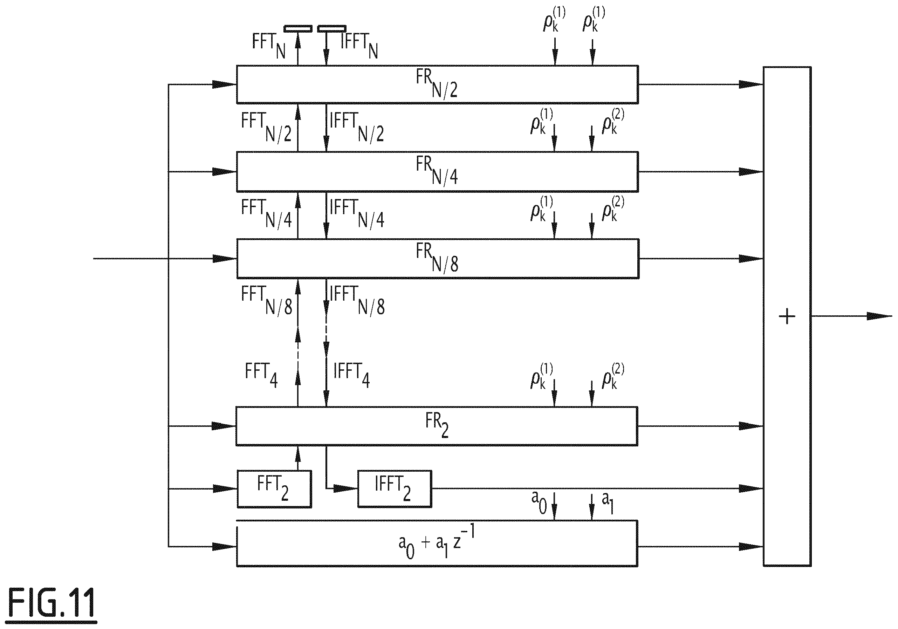

Pour faciliter la comparaison entre les différents filtres, les signes de référence des éléments relatifs au filtre des figures 1 à 5 (et ultérieurement des figures 11 à 14) sont basés sur le signe de référence 18 alors que les signes de référence des éléments relatifs au filtre des figures 6 à 8 sont basés sur la figure 2. Ainsi, le terme « filtre 18 » est utilisé dans la suite de la description pour désigner un filtre tel que décrit dans l'une des figures 1 à 5 et 11 à 14 tandis que le terme « filtre 100 » est utilisé pour désigner un filtre tel que décrit dans l'une des figures 6 à 8.

Néanmoins, il sera compris que des remarques s'appliquant au filtre 18 sont également valables pour le filtre 100 et de telles remarques ne sont pas répétées dans ce qui suit.

A titre d'exemple, le filtre 18 comporte une entrée 18E et une sortie 18S. De manière correspondante, le filtre 100 comporte une entrée 100E et une sortie 100S.

Réciproquement, des remarques s'appliquant au filtre 100 sont également valables pour le filtre 18 lorsque cela est techniquement possible.

Comme illustré par la figure 6, le filtre 100 comprend une première voie 1001, une deuxième voie 1002, un transmetteur 1003 et un mélangeur 1004.

La borne d'entrée 100E est propre à recevoir un signal d'entrée.

La première voie 1001 est propre à obtenir un premier signal de sortie par la mise en oeuvre de premières opérations.

La première voie 1001 est propre à mettre en oeuvre une première opération de premier traitement du signal d'entrée pour obtenir un signal traité.

Selon l'exemple de la figure 6, le premier traitement est l'envoi du signal d'entrée.

La première voie 1001 est également propre à appliquer une transformée de Fourier discrète à M points sur le signal traité pour obtenir M points de spectre du signal traité, M étant un nombre entier strictement supérieur à 2, chaque point de spectre du signal traité correspondant aux indices pairs d'une analyse spectrale à 2*M points du signal traité et étant repéré de manière bijective par un indice k, k étant un nombre pair compris entre 0 et 2*M-1. Dans ce cas, les points sont numérotés de 0 à 2*M-1 .

Cela revient à calculer les coefficients pairs de l'analyse spectrale à 2*M points du signal traité.

Par exemple, la transformée de Fourier discrète calculée est une transformée de Fourier rapide notée $FFT_M$.

Cela est illustré schématiquement sur la figure 2 par une boîte dans laquelle il est inscrit $FFT_M$ et par un multiplieur sur lequel arrive une flèche avec l'inscription « p2m ».

La première voie 1001 est aussi propre à mettre en oeuvre une première opération de deuxième traitement des points de spectre du signal traité pour obtenir des premiers points sélectionnés.

La première voie 1001 est propre à mettre en oeuvre le décalage des points de spectre du signal traité de M échantillons pour obtenir des points décalés et le calcul de la somme des points de spectre du signal traité et des points décalés.

Le décalage est illustré schématiquement sur la figure 6 par une boîte dans laquelle il est inscrit « $z^{-M}$ » par référence à une technique de décalage par utilisation de la transformée en Z.

Un signe somme sur lequel arrive deux flèches, l'une correspondant à un trajet passant par la boîte dans laquelle il est inscrit « $z^{-M}$ » et l'autre correspondant à un trajet n'y passant pas montre schématiquement la première opération de deuxième traitement.

La première voie 1001 est également propre à mettre en oeuvre une première opération d'application de la transformée de Fourier discrète inverse à M points sur les premiers points sélectionnés pour obtenir un premier signal.

Par exemple, la transformée de Fourier discrète calculée est une transformée de Fourier rapide notée $IFFT_M$.

Cela est illustré schématiquement sur la figure 6 par une boîte dans laquelle il est inscrit $IFFT_M$.

La première voie 1001 est aussi propre à mettre en oeuvre une première opération de troisième traitement du premier signal pour obtenir un premier signal de sortie.

En l'occurrence, la première opération du troisième traitement consiste à transmettre le premier signal de sortie vers le mélangeur 1004.

La deuxième voie 1002 est propre à obtenir un deuxième signal de sortie par la mise en oeuvre de deuxièmes opérations.

La deuxième voie 1002 est propre à mettre en oeuvre une deuxième opération de premier traitement du signal d'entrée pour obtenir un signal traité.

En l'occurrence, la deuxième voie 1002 est propre à mettre en oeuvre une translation fréquentielle d'une valeur égale au ratio entre la fréquence d'échantillonnage et le nombre 2*M.

Une telle opération est symbolisée par une flèche sur un multiplieur, flèche sur laquelle est inscrite « $e^{-2j\pi n/N}$ » par référence à une technique usuelle de translation qui consiste à multiplier le signal par une exponentielle complexe bien choisie.

La deuxième voie 1002 est propre à mettre en oeuvre une deuxième opération d'application d'une transformée de Fourier discrète à M points sur le signal traité pour obtenir M points de spectre du signal traité, chaque point de spectre du signal traité correspondant aux indices impairs d'une analyse spectrale à 2*M points du signal traité et étant repéré de manière bijective par un indice k, k étant un nombre impair compris entre 0 et 2*M-1 .

La deuxième voie 1002 est propre à mettre en oeuvre une deuxième opération de deuxième traitement des points de spectre du signal traité pour obtenir des deuxièmes points sélectionnés.

La deuxième voie 1002 est ainsi propre à mettre en oeuvre le décalage des points de spectre du signal traité de M échantillons pour obtenir des points décalés et le calcul de la somme des points de spectre du signal traité et des points décalés. Du point de vue du signal, le décalage est un retard temporel.

Le décalage est illustré schématiquement sur la figure 6 par une boîte dans laquelle il est inscrit « $z^{-M}$ » par référence à une technique de décalage par utilisation de la transformée en Z.

Un signe somme sur lequel arrive deux flèches, l'une correspondant à un trajet passant par la boîte dans laquelle il est inscrit « $z^{-M}$ » et l'autre correspondant à un trajet n'y passant pas montre schématiquement la deuxième opération de deuxième traitement.

La deuxième voie 1002 est aussi propre à mettre en oeuvre une deuxième opération d'application de la transformée de Fourier discrète inverse à M points sur les deuxièmes points sélectionnés pour obtenir un deuxième signal.

La deuxième voie 1002 est également propre à mettre en oeuvre une deuxième opération de troisième traitement du deuxième signal pour obtenir un deuxième signal de sortie.

En l'occurrence, la deuxième voie 1002 est propre à mettre en oeuvre une translation fréquentielle d'une valeur opposée au ratio entre la fréquence d'échantillonnage et le nombre 2*M.

Une telle opération est symbolisée par une flèche sur un multiplieur, flèche sur laquelle est inscrite « $e^{-2j\pi n/N}$ » par référence à une technique usuelle de translation qui consiste à multiplier le signal par une exponentielle complexe bien choisie.

Le transmetteur 1003 est propre à transmettre le signal d'entrée sur la première voie 1001 et la deuxième voie 1002.

Le mélangeur 1004 est propre à recombiner le premier signal de sortie et le deuxième signal de sortie pour obtenir le signal filtré.

En l'occurrence, comme la recombinaison est obtenue par une différence du premier signal de sortie et du deuxième signal de sortie, le mélangeur 1004 est représenté par un cercle avec un signe + et un signe -.

Le fonctionnement du deuxième filtre 100 est maintenant décrit en référence à un exemple de mise en oeuvre d'un procédé de filtrage d'un signal d'entrée numérique échantillonné à une fréquence d'échantillonnage pour obtenir un signal filtré.

Le procédé comprend une étape de fourniture, une étape de transmission, une étape d'obtention d'un premier signal de sortie, une étape d'obtention d'un deuxième signal de sortie et une étape de recombinaison.

A l'étape de fourniture, le signal d'entrée est fourni sur la borne d'entrée 100E du deuxième filtre 100.

A l'étape de transmission, le signal d'entrée est transmis par le transmetteur 1003 sur les deux voies 1001 et 1002.

A l'étape d'obtention du premier signal de sortie, il est calculé la transformée de Fourier rapide à M points du signal d'entrée pour obtenir les coefficients d'ordre pair d'une analyse spectrale à 2*M points du signal d'entrée.

Il est ensuite réalisé une première opération de mise en oeuvre du décalage des points de spectre du signal traité de M échantillons pour obtenir des points décalés et le calcul de la somme des points de spectre du signal traité et des points décalés. Des premiers points sélectionnés sont ainsi obtenus.

Il est ensuite appliqué une application de la transformée de Fourier discrète inverse à M points sur les premiers points sélectionnés pour obtenir un premier signal de sortie.

Le premier signal de sortie est envoyé au transmetteur 1003.

A l'étape d'obtention du deuxième signal de sortie, il est mis en oeuvre d'une translation fréquentielle d'une valeur égale au ratio entre la fréquence d'échantillonnage et le nombre 2*M. Un signal traité est ainsi obtenu.

Il est calculé la transformée de Fourier rapide à M points du signal traité pour obtenir les coefficients d'ordre impair d'une analyse spectrale à 2*M points du signal d'entrée.

Il est ensuite réalisé une deuxième opération de mise en oeuvre du décalage des points de spectre du signal traité de M échantillons pour obtenir des points décalés et le calcul de la somme des points de spectre du signal traité et des points décalés. Des deuxièmes points sélectionnés sont ainsi obtenus.

Il est ensuite appliqué une application de la transformée de Fourier discrète inverse à M points sur les deuxièmes points sélectionnés pour obtenir un deuxième signal.

Il est ensuite mis en oeuvre une mise en oeuvre d'une translation fréquentielle appliquée au deuxième signal d'une valeur égale à l'opposé du ratio entre la fréquence d'échantillonnage et le nombre 2*M. Cela permet d'obtenir un signal de sortie.

L'étape de recombinaison est ensuite mise en oeuvre à l'aide du mélangeur 1004 pour obtenir le signal filtré en effectuant la différence entre le premier signal de sortie et le deuxième signal de sortie.

Le procédé permet d'obtenir un signal filtré de manière plus aisée.

De fait, le procédé, par rapport à un procédé de l'état de la technique, permet de limiter la place mémoire requise de 40% comme cela est démontré en commentant la figure 9.

De plus, il est également possible de mutualiser les calculs puisque les deux voies 1001 et 1002 sont synchrones.

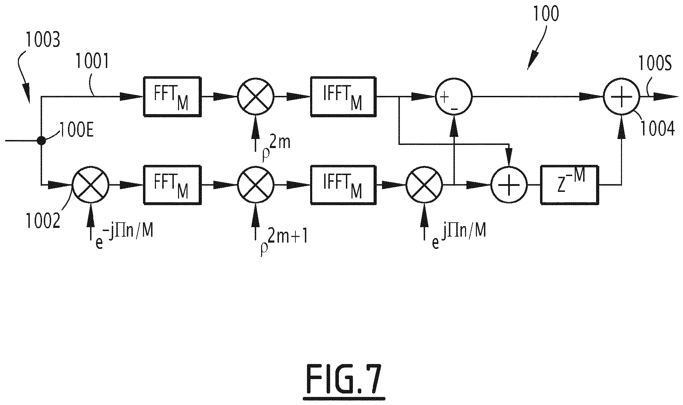

En variante, le deuxième filtre 100 est conforme au mode de réalisation de la figure 7.

Les éléments identiques au mode de réalisation de la figure 6 ne sont pas décrits à nouveau. Seules les différences sont mises en évidence.

Le deuxième filtre 100 selon le mode de réalisation de la figure 7 diffère du deuxième filtre 100 selon le mode de réalisation de la figure 6 par les opérations que les première voie 1001 et deuxième voie 1002 sont propres à mettre en oeuvre et par la nature des opérations effectuées lors de l'étape de recombinaison.

Dans le cas de la figure 6, chacune des premières opérations de premier traitement et de deuxième traitement consiste à transmettre le signal considéré.

Dans le cas de la figure 7, la deuxième opération de premier traitement comprend la mise en oeuvre d'une translation fréquentielle d'une valeur égale au ratio entre la fréquence d'échantillonnage et le nombre 2*M.

Le deuxième traitement consiste à transmettre le signal considéré.

La deuxième opération de troisième traitement comprend la mise en oeuvre d'une translation fréquentielle appliquée au deuxième signal d'une valeur égale à l'opposé du ratio entre la fréquence d'échantillonnage et le nombre 2*M.

A l'étape de recombinaison, il est calculé la différence entre le premier signal de sortie et le deuxième signal de sortie, pour obtenir un premier signal de calcul.

Il est ensuite calculé la somme du premier signal de sortie et du deuxième signal de sortie, pour obtenir un deuxième signal intermédiaire de calcul.

Il est aussi mis en oeuvre un décalage du deuxième signal intermédiaire de calcul de M échantillons pour obtenir un deuxième signal de calcul.

Il est également calculé la somme du premier signal de calcul et du deuxième signal de calcul pour obtenir le signal filtré.

Les mêmes avantages concernent le mode de réalisation selon la figure 7.

Selon une autre variante, le deuxième filtre 100 est conforme au mode de réalisation de la figure 6.

Les éléments identiques au mode de réalisation de la figure 6 ne sont pas décrits à nouveau. Seules les différences sont mises en évidence.

Le deuxième filtre 100 selon le mode de réalisation de la figure 8 diffère du deuxième filtre 100 selon le mode de réalisation de la figure 6 par les opérations que les première voie 1001 et deuxième voie 1002 sont propres à mettre en oeuvre.

Dans le cas de la figure 8, la première opération de premier traitement met en oeuvre le décalage du signal d'entrée de M échantillons pour obtenir un signal décalé et le calcul de la somme du signal d'entrée et du signal décalé.

Chaque première opération de deuxième traitement et de troisième traitement consiste à transmettre le signal.

Selon l'exemple de la figure 8, la deuxième opération de premier traitement met en oeuvre le décalage du signal d'entrée de M échantillons pour obtenir un signal décalé et le calcul de la somme du signal d'entrée et du signal décalé. La deuxième opération de premier traitement met ensuite en oeuvre une translation fréquentielle d'une valeur égale au ratio entre la fréquence d'échantillonnage et le nombre 2*M.

La deuxième opération de deuxième traitement consiste à transmettre le signal.

La deuxième opération de troisième traitement met en oeuvre une translation fréquentielle appliquée au deuxième signal d'une valeur égale à l'opposé du ratio entre la fréquence d'échantillonnage et le nombre 2*M.

Les mêmes avantages concernent le mode de réalisation selon la figure 8.

Dans la section qui suit, en référence à la figure 9, il est montré que les calculs proposés permettent d'obtenir le filtrage désiré.

Pour calculer une tranche de M points de sortie, il est utilisé une tranche de 2M points $a_n$ pour des indices n qui, par convention, seront tels que $0 \leq n \leq 2*M-1$.

Pour comprendre la suite du calcul, il convient d'expliciter des généralités sur la décomposition d'une transformée de Fourier discrète (TFD) en Radix (x étant le nombre de points factorisables).

La transformée de Fourier discrète à N points d'une séquence de N points $X_n$ (N étant un nombre entier) vaut :

$$X_m = \sum_{n=0}^{N-1} x_n e^{-j2\pi\frac{n\times m}{N}}$$

Dans le cas où N est le produit $N = N_1 \times N_2$ de deux nombres entiers $N_1$ et $N_2$, il peut être écrit :

$$X_{m_1 N_2 + m_2} = \sum_{n_1=0}^{N_1-1}\sum_{n_2=0}^{N_2-1} x_{n_2 N_1 + n_1} e^{-j2\pi\frac{(n_2 N_1 + n_1)\times(m_1 N_2 + m_2)}{N_1 N_2}} = \sum_{n_1=0}^{N_1-1}\sum_{n_2=0}^{N_2-1} x_{n_2 N_1 + n_1} e^{-j2\pi\frac{n_1\times m_2}{N_1 N_2}} e^{-j2\pi\frac{n_1\times m_1}{N_1}} e^{-j2\pi\frac{n_2\times m_2}{N_2}}$$

La transformée de Fourier discrète correspond à la cascade d'une transformée de Fourier discrète à $N_2$ points et d'une transformée de Fourier discrète à $N_1$ points

Dans une réalisation naturelle de la FFT, la transformée de Fourier discrète à $N_2$ points (« multiplexée ») est suivie de la transformée de Fourier à $N_1$ points (« rapide »), ce qui correspond à :

$$\underbrace{X_{m_1 N_2 + m_2}}_{\substack{0\leq m_1 \leq N_1-1 \\ 0\leq m_2 \leq N_2-1}} = \sum_{n_2=0}^{N_2-1}\sum_{n_1=0}^{N_1-1} x_{n_2 N_1 + n_1} \times e^{-j2\pi\frac{(n_2 N_1 + n_1)\times(m_1 N_2 + m_2)}{N_1 N_2}} = \underbrace{\sum_{n_1=0}^{N_1-1} e^{-j2\pi\frac{n_1 m_1}{N_1}} \times \underbrace{e^{-j2\pi\frac{n_1 m_2}{N_1 N_2}}}_{\substack{\text{tweedle} \\ \text{factors}}} \times \underbrace{\sum_{n_2=0}^{N_2-1} x_{n_2 N_1 + n_1} e^{-j2\pi\frac{n_2 m_2}{N_2}}}_{\substack{\text{FFT à } N_2 \text{ points} \\ \text{multiplexée par } N_1 \\ (\text{radix } N_2)}}}_{\substack{\text{FFT à } N_1 \text{ points} \\ (\text{radix } N_1)}}$$

Par définition, l'indice rapide du temps $n_1$ arrive dans le temps court. L'indice lent des fréquences $m_1$ sort dans le temps cours et l'indice rapide des fréquences $m_2$ sort dans le temps long (« bit reverse »). et se conclut par

La seconde des transformées de Fourier discrètes mises en jeu est pondérée par un oscillateur local permettant un décalage fin du spectre ; le terme exponentiel permettant cette translation est appelé « tweedle factor » :

$$\text{tweedle factor} = e^{-j2\pi\frac{n_1 \times m_2}{N_1 N_2}}$$

Par principe, l'indice de sortie variant le plus rapidement est $m_1$. Puisqu'il correspond à la transformée de Fourier discrète « rapide » c'est-à-dire non multiplexée. Ainsi, l'ordre de sortie des fréquences n'est pas l'ordre naturel : en effet, sortent d'abord les m valant 0 modulo $N_1$ puis les m valant 1 et ainsi de suite jusqu'aux m valant $N_1 - 1$ toujours 0 modulo $N_1$ ; cet ordre est appelé « bit reverse » car cela correspond à renverser la représentation binaire de l'indice pour obtenir le rang de sortie (pour un nombre de points en puissance de 2).

La réalisation de la transformée de Fourier discrète inverse, qui récupère les data fréquentielles en « bit reverse », s'effectue de façon duale, par retournement des opérations (conjugaison des tweedle factors, IFFT rapide à $N_1$ points suivie d'une IFFT mutiplexée à $N_2$ points).

$$\underbrace{x_{n_2 N_1 + n_1}}_{\substack{0 \le n_1 \le N_1 - 1 \\ 0 \le n_2 \le N_2 - 1}} = \sum_{n_2=0}^{N_2-1} \sum_{n_1=0}^{N_1-1} X_{m_1 N_2 + m_2} \times e^{+j2\pi\frac{(n_2 N_1 + n_1) \times (m_1 N_2 + m_2)}{N_1 N_2}} = \underbrace{\sum_{m_2=0}^{N_2-1} e^{+j2\pi\frac{n_2 m_2}{N_2}} \times \underbrace{\underbrace{e^{+j2\pi\frac{n_1 m_2}{N_1 N_2}}}_{\substack{\text{tweedle} \\ \text{factors}}} \times \underbrace{\sum_{m_1=0}^{N_1-1} X_{m_1 N_2 + m_2} e^{+j2\pi\frac{n_1 m_1}{N_1}}}_{\substack{\text{FFT à } N_1 \text{ points} \\ (\text{radix } N_1)}}}}_{\substack{\text{FFT à } N_2 \text{ points} \\ \text{multiplexée par } N_1 \\ (\text{radix } N_2)}}$$

L'indice lent des fréquences $m_1$ arrive dans le temps cours et l'indice rapide des fréquences $m_2$ arrive dans le temps long (« bit reverse »).

L'indice rapide du temps $n_1$ ressort dans le temps court.

Ainsi, la réalisation s'effectue comme la cascade d'une transformée de Fourier discrète à $N_2$ points multiplexée par $N_1$ et d'une transformée de Fourier discrète à $N_1$ points non multiplexée. Le « tweedle factor » est placé entre les deux étages de transformée de Fourier discrète. La première transformée de Fourier discrète réalisée étant multiplexée, cette décomposition s'accommode de data d'entrée parallélisées ; le multiplexage se transforme alors en traitement en parallèle.

Par ailleurs, suivant cette réalisation classique la FFT à 2M points, une décomposition en radix2 et radix M comme une suite $a_n$ s'écrit donc:

$$a_m = \sum_{n=0}^{2M-1} x_n e^{-j2\pi\frac{n \times m}{2M}} = \sum_{n=0}^{M-1} \left( x_n + (-1)^m x_{n+M} \right) e^{-j2\pi\frac{n \times m}{2M}} = \sum_{n=0}^{M-1} x_n e^{-j2\pi\frac{n \times m}{2M}} + (-1)^m \sum_{n=0}^{M-1} x_{n+M} e^{-j2\pi\frac{n \times m}{2M}}$$

$$b_m = \sum_{n=0}^{2M-1} a_n e^{-j2\pi n m/(2M)} = \sum_{n=0}^{M-1} a_n e^{-j2\pi n m/(2M)} + (-1)^m \sum_{n=0}^{M-1} a_{M+n} e^{-j2\pi n m/(2M)}$$

En particulier :

$$b_{2m+p} = \sum_{n=0}^{M-1} a_n e^{-j2\pi n p/(2M)} e^{-j2\pi n m/M} + (-1)^p \sum_{n=0}^{M-1} a_{M+n} e^{-j2\pi n p/(2M)} e^{-j2\pi n m/M}$$

Où $p = \begin{cases} 0 \\ 1 \end{cases}$ soit :

$$b_{2m+p} = \text{FFT}_M \left( a_n e^{-j\pi n p/M} \right) + (-1)^p \text{FFT}_M \left( a_{M+n} e^{-j\pi n p/M} \right)$$

où $\text{FFT}_M$ désigne la FFT à M points.

Il est à noter que cette densité spectrale s'écrit également des deux façons suivantes qui en simplifieront la mise en oeuvre :

$$b_{2m+p} = \text{FFT}_M\left(a_n e^{-j\pi n p/M}\right) + \text{FFT}_M\left(a_{M+n} e^{-j\pi(M+n)p/M}\right)$$

et

$$b_{2m+p} = \text{FFT}_M\left(\left[(-1)^p a_n + a_{M+n}\right]e^{-j\pi(M+n)p/M}\right)$$

En notant $p_m$ la réponse spectrale du filtre, il est obtenu la réponse filtrée par transformation inverse :

$$c_k = \sum_{p=0}^{1}\sum_{m=0}^{M-1} b_{2m+p}\rho_{2m+p} e^{j2\pi k(2m+p)/(2M)} = \sum_{p=0}^{1} e^{j2\pi kp/(2M)}\sum_{m=0}^{M-1} b_{2m+p}\rho_{2m+p} e^{j2\pi km/M}$$

La réponse est calculée uniquement pour les points $0 \leq k \leq M-1$ (du fait du repliement inhérent à la FFT) pour obtenir finalement :

$$c_k = \sum_{p=0}^{1} e^{j\pi kp/M}\,\text{IFFT}_M\left(b_{2m+p}\rho_{2m+p}\right)$$

où la IFFT$_M$ désigne la FFT inverse à M points.

Des formules donnant $b_{2m+p}$ et $c_k$ il peut être obtenu les schémas-blocs précédentsqui permettent de réaliser des convolutions avec des réponses de taille double en utilisant la même taille de FFT et d'IFFT, moyennant une mémorisation sur M points.

Il est alors obtenu le schéma-bloc de la figure 6. Un tel schéma-bloc correspond à la première formulation de la densité spectrale $b_{2m+p}$.

En faisant glisser la fonction de mémorisation vers la sortie on peut la réduire de moitié, ce qui conduit au schéma-bloc de la figure 7.

Enfin, le glissement de la mémorisation vers l'entrée, qui correspond en fait à la seconde formulation de la densité spectrale $b_{2m+p}$, conduit au schéma-bloc de la figure 8 qui peut être considéré comme une version duale du schéma-bloc de la figure 7.

Les opérations mises en jeu dans ces schémas-blocs correspondent au premier rang (pour la FFT) ou au dernier rang (pour l'IFFT) de « tweedle factors » non pris en compte, par principe, dans la FFT à M points. Théoriquement, ces opérations numériques sont à réinitialiser à chaque trame de FFT.

Il est cependant à constater que cela n'est en fait pas nécessaire dans la pratique car, en l'absence de réinitialisation, le signe de ces opérations change à chaque trame, si bien que les deux changements de signe se compensent.

Il peut être démonté qu'un tel filtrage est plus économe en termes de ressources mémoire dans le cas où une réalisation dans le flot est requise.

Lorsque le filtrage correspond au filtrage adapté à un signal donné (une impulsion reçue par exemple), le gain complexe du filtre adapté est le conjugué du spectre de l'impulsion. Si ce spectre est obtenu par FFT à 2M points d'une impulsion démarrant à n = 0 et se terminant avant n = M, alors la réponse temporelle du filtre adapté se trouve alors placée dans les temps négatifs.

Si $r_n$ est l'impulsion et si $x_n$ est le signal reçu, le filtrage adapté réalise l'opération suivante, qui est le calcul de l'autocorrélation de l'impulsion lorsque le signal reçu $x_n$ est égal à l'impulsion $r_n$, le pic de corrélation arrivant au début de l'impulsion :

$$y_q = \sum_{k=0}^{M-1} r_k^* x_{q+k}$$

Le conjugué du gain complexe du filtre adapté vaut :

$$\begin{cases} \rho_{2m}^* = \sum_{n=0}^{2M-1} r_n e^{-j2\pi n(2m)/(2M)} = \sum_{n=0}^{M-1} r_n e^{-j2\pi nm/M} + \sum_{n=0}^{M-1} r_{M+n} e^{-j2\pi nm/M} \\ \rho_{2m+1}^* = \sum_{n=0}^{2M-1} r_n e^{-j2\pi n(2m+1)/(2M)} = \sum_{n=0}^{M-1} r_n e^{-j2\pi n/(2M)} e^{-j2\pi nm/M} - \sum_{n=0}^{M-1} r_{M+n} e^{-j2\pi n/(2M)} e^{-j2\pi nm/M} \end{cases}$$

Etant donné que l'impulsion est nulle pour les temps négatifs, il est alors obtenu le résultat de deux FFT à M points :

$$\rho_{2m}^* = \sum_{n=0}^{M-1} r_n e^{-j2\pi nm/M}$$

et

$$\rho_{2m+1}^* = \sum_{n=0}^{M-1} r_n e^{-j\pi n/M} e^{-j2\pi nm/M}$$

Ceci donne au schéma-bloc de vérification de la figure 9 une vision plus symétrique permettant de vérifier directement que chaque implémentation du deuxième filtre 100 permet effectivement d'aboutir au résultat escompté.

En entrée de l'IFFT de la première voie 1001, il est obtenu :

$$\sum_{n=0}^{M-1} \xi_n e^{-j2\pi nm/M} \sum_{k=0}^{M-1} r_k^* e^{+j2\pi km/M} = \sum_{n=0}^{M-1} \sum_{k=0}^{M-1} \xi_n r_k^* e^{-j2\pi(n-k)m/M} = \sum_{q=0}^{M-1} e^{-j2\pi qm/M} \sum_{n=0}^{M-1} \xi_n r_{\mathrm{mod}(n-q,M)}^*$$

Il est obtenu en sortie de cette IFFT de la première voie 1001 :

$$\sum_{n=0}^{M-1} \xi_n r_{\mathrm{mod}(n-q,M)}^*$$

Pour la deuxième voie 1002, en entrée de l'IFFT, il est obtenu :

$$\sum_{n=0}^{M-1} \xi_n e^{-j\pi n/M} e^{-j2\pi nm/M} \sum_{k=0}^{M-1} r_k^* e^{+j\pi k/M} e^{+j2\pi km/M} = \sum_{k-n=-n}^{-n+M-1} \sum_{n=0}^{M-1} \xi_n r_k^* e^{-j\pi(n-k)/M} e^{-j2\pi(n-k)m/M}$$

Ces dernières équations s'écrivent :

$$\sum_{n-k=n+1-M}^{n} \sum_{n=0}^{M-1} \xi_n r_k^* e^{-j\pi(n-k)/M} e^{-j2\pi(n-k)m/M} = \sum_{q=0}^{M-1} e^{-j\pi q/M} e^{-j2\pi qm/M} \sum_{n=0}^{M-1} \xi_n r_{\mathrm{mod}(n-q,M)}^* \, \mathrm{sign}(n-q)$$

où

$$\mathrm{sign}(n-q) = \begin{cases} -1 & \mathrm{si}\ n < q \\ +1 & \mathrm{si}\ n \geq q \end{cases}$$

Enfin, à titre de remarque, il est à noter que, pour des IFFT normalisées (par NFFT ce qui conduit à FFT * IFFT = 1) une voie réalise le double de la réponse impulsionnelle. Il convient en tenir compte dans les coefficients qui devraient être divisés par 2, sauf ceux de la partie FIR. La réalisation d'une IFFT normalisée est obtenue en reportant le coefficient de normalisation dans les coefficients en sus du facteur 2 évoqué juste avant.

La comparaison entre les filtres 18 des figures 2 à 5 et les filtres 100 des figures 6 à 8 montre que, fonctionnellement, les opérations appliquées (même si elles diffèrent par l'ordre et/ou la nature de l'opération) conduisent au même résultat en sortie.

Les filtres 18 des figures 2 à 5 présentent une latence réduite par rapport aux filtres proposés dans les figures 6 à 8.

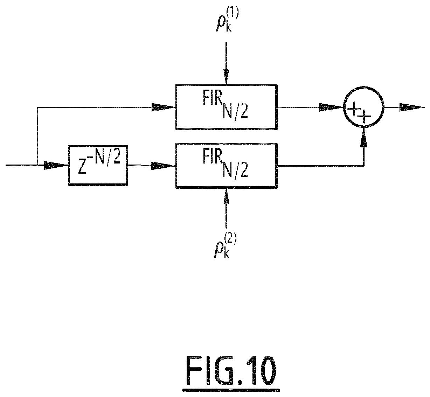

Plus précisément, la latence est réduite de moitié par application du principe illustré par le montage de la figure 10.

Un tel principe est maintenant décrit.

Il est noté $FIR_N$ la réalisation d'un FIR de durée maximale N suivant le principe présenté précédemment. Une telle réalisation présente donc des latences égales à 2N. La latence d'un filtre est, dans ce contexte, le retard supplémentaire du filtre par rapport au filtre théorique réalisant le même filtrage

La fonction réalisée par le traitement $FIR_N$ sur un signal $x_k$ est la suivante :

$$y_k = \sum_{n=0}^{N-1} a_n x_{k-n}$$

Une telle fonction peut être réécrite en faisant apparaître deux parties complémentaires de durée N/2 dans la réponse temporelle du FIR :

$$y_k = \sum_{n=0}^{-1+N/2} a_n x_{k-n} + \sum_{n=N/2}^{N-1} a_n x_{k-n} = \sum_{n=0}^{-1+N/2} a_n x_{k-n} + \sum_{n=0}^{-1+N/2} a_{n+N/2} x_{(k-N/2)-n}$$

Une telle expression correspond à la somme des deux réponses, respectivement première réponse et deuxième réponse.

La première réponse peut être interprétée comme le filtrage des x pour les temps k à k - (N/2-1) par la première partie de la réponse du FIR tandis que la deuxième réponse est interprétable comme le filtrage des x pour les temps k - N/2 à k - (N-1) par la seconde partie de la réponse du FIR.

Chacune de ces deux réponses peut alors être réalisée par une structure $FIR_{N/2}$ dont la latence est N comme illustré par le montage de la figure 10.

L'application de ce principe aux filtres 50 des figures 7 à 9 conduit aux filtres 18 des figures 2 à 5.

Le filtre 18 présente donc une latence réduite. Un tel filtre sera noté par la suite $FR_N$.

La généralisation d'un tel principe conduit à un procédé de filtrage d'un signal d'entrée numérique échantillonné à une fréquence d'échantillonnage pour obtenir un signal filtré.

Le procédé comporte au moins une étape de fourniture d'un signal d'entrée, une étape de transmission du signal d'entrée sur deux voies de traitement, une étape d'obtention d'un premier signal de sortie, une étape d'obtention d'un deuxième signal de sortie, une étape d'application d'une transformée de Fourier et une étape de recombinaison.

Lors de l'étape d'obtention du premier signal de sortie, il est obtenu un premier signal de sortie par la mise en oeuvre de premières opérations sur la première voie de traitement, les premières opérations comportant au moins l'application d'un filtrage impliquant une transformée de Fourier discrète à M/2 points sur un signal issu du signal d'entrée, le filtrage présentant une latence de M.

Lors de l'étape d'obtention du deuxième signal de sortie, il est mis en oeuvre des deuxièmes opérations sur la deuxième voie de traitement, les deuxièmes opérations comportant au moins l'application d'un décalage de M/2 points à un signal issu du signal d'entrée puis l'application d'un filtrage impliquant une transformée de Fourier discrète à M/2 points sur le signal décalé, le filtrage présentant une latence de M.

Lors de l'étape d'application, il est appliqué une transformée de Fourier discrète inverse à M/2 points sur le premier signal pour obtenir M points de spectre du premier signal, M étant un nombre entier strictement supérieur à 2.

Lors de l'étape de recombinaison, les résultats de deux voies de traitement sont recombinés.

Selon un exemple particulier, le procédé comporte une opération d'addition d'un signal d'entrée et du signal d'entrée décalé de N/2 points, le signal obtenu après addition étant le signal d'entrée de la première voie de traitement.

Selon un autre exemple ou en complément, le procédé comporte une opération d'addition d'un signal d'entrée et du signal d'entrée décalé de N points, le signal obtenu après addition étant le signal d'entrée de la deuxième voie de traitement.

Selon encore un autre exemple, l'opération de décalage de N points est appliquée à l'aide de deux sous-unités 40 et 42.

Selon un exemple, les premières opérations comportent un premier traitement du signal d'entrée pour obtenir un signal traité, une opération de mise en en oeuvre de l'étape d'application d'une transformée de Fourier discrète à M points sur le signal traité, chaque point de spectre du signal traité correspondant aux indices pairs d'une analyse spectrale à 2*M points du signal traité et étant repéré de manière bijective par un indice k, k étant un nombre pair compris entre 0 et 2*M-1, un deuxième traitement des points de spectre du signal traité pour obtenir des premiers points sélectionnés, une application de la transformée de Fourier discrète inverse à M points sur les premiers points sélectionnés pour obtenir un premier signal, et un troisième traitement du premier signal pour obtenir un premier signal de sortie.

Selon un autre exemple, les deuxièmes opérations comportent un premier traitement du signal d'entrée pour obtenir un signal traité, une opération de mise en en oeuvre de l'étape d'application d'une transformée de Fourier discrète à M points sur le signal traité, chaque point de spectre du signal traité correspondant aux indices impairs d'une analyse spectrale à 2*M points du signal traité et étant repéré de manière bijective par un indice k, k étant un nombre pair compris entre 0 et 2*M-1, un deuxième traitement des points de spectre du signal traité pour obtenir des premiers points sélectionnés, une application de la transformée de Fourier discrète inverse à M points sur les premiers points sélectionnés pour obtenir un deuxième signal, et un troisième traitement du deuxième signal pour obtenir un deuxième signal de sortie.

Le principe décrit précédemment peut être généralisé pour obtenir une annulation de la latence.

L'annulation de la latence s'appuie alors sur le développement suivant :

$$N/2 + N/4 + \dots + 2 + 1 = N - 1.$$

Puisque chaque structure $FR_N$ possède une latence intrinsèque égale à N, un tel développement permet de proposer une architecture à latence nulle comme illustré sur la figure 11.

Le filtre 18 de la figure 11 comporte une pluralité d'étages correspondant à chaque membre du développement. Le premier étage correspond au chiffre 1, le deuxième étage au chiffre 2, ..., le N/8-ième étage au chiffre N/8, le N/4-ième étage au chiffre N/4 et le N/2-ième étage au chiffre N/2.

Le filtre 18 utilise la capacité d'un étage de réaliser une FFT et une IFFT pour l'étage suivant.

Dans cette figure 11, chaque k-ième voie $FR_k$ est formée par des éléments permettant la réalisation d'un FIR à k coefficients retardé de k.

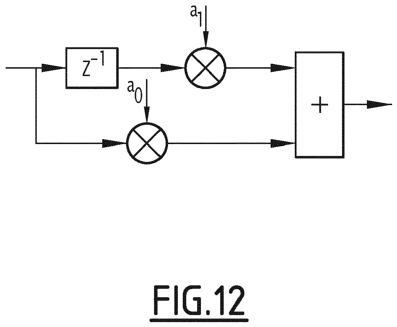

A titre d'exemple, pour le premier étage, la boîte FIR, est réalisé par le FIR représenté à la figure 12.

Plus précisément, le FIR, comporte un additionneur propre à additionner une première voie avec une boîte $z^{-1}$ suivie d'un mélangeur $a_1$ et une deuxième voie comportant un mélangeur $a_2$, les entrées des deux voies étant confondues.

Le FIR, peut ainsi être désigné comme $a^0 + a_1 z^{-1}$.

Dans le cas de faibles valeurs de k, en particulier pour k = 2 et k = 4, voire même pour k = 8 et k = 16, il peut être plus pertinent de remplacer la réalisation des figures 11 et 12 par une réalisation moins gourmande en ressources de calcul pour de faibles valeurs de k.

Par définition, une valeur de k est faible lorsque k est inférieure à 256.

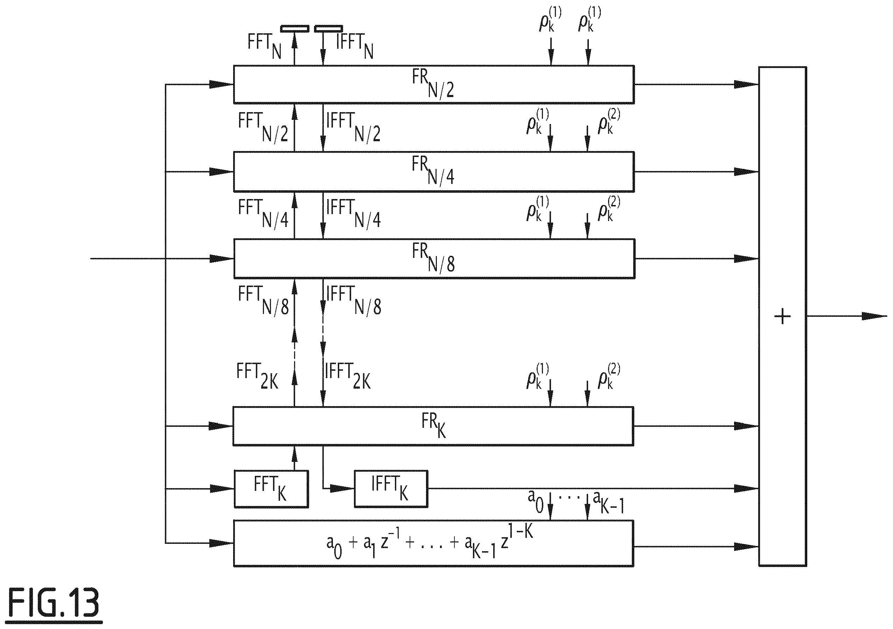

Dans un tel cas, l'architecture de filtre 18 correspondante est celle de la figure 13.

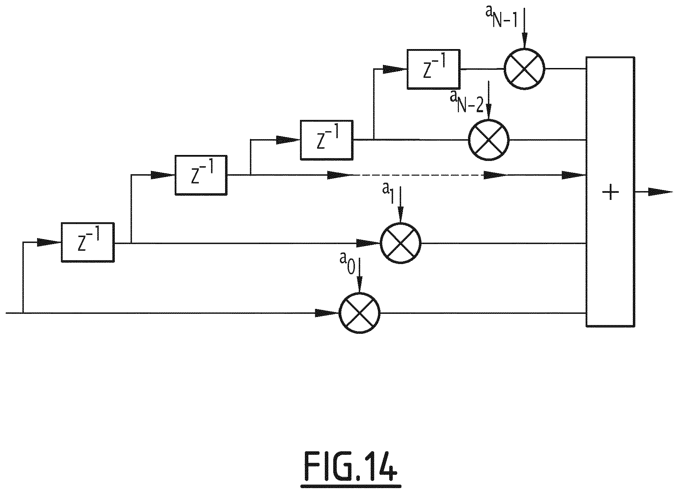

L'architecture de filtre 18 diffère notamment au premier étage, le premier étage comportant des éléments réalisant une opération $FR_K$. Une telle opération est visible sur la figure 14.

Un tel filtre 18 permet d'obtenir une latence nulle par l'emploi de ressources complémentaires qui sont maintenant évaluées.

Il convient de rappeler que la mise en oeuvre qu'une opération de FFT ou une opération de IFFT de longueur $N = 2^M$ requiert les ressources suivantes, 2M additions et M/2 multiplications.

Dans les équations mathématiques, il pourra être noté « ADD » pour les additions et « MUL » pour les multiplications.

Il en résulte qu'une structure de type $FR_N$ requiert alors les ressources suivantes pour le filtre 18 :

- 2 x (M-1) + 6 = 2 (M + 2) additions, et
- 2 x (M-1)/2 + 6 = M + 5 multiplications.

Dans le cas où la réponse temporelle du filtre 18, de longueur $N = 2^M$, est réalisée sous forme de FIR jusqu'à l'indice $2^K$-1, les ressources requises comportent de multiples éléments.

En particulier, les ressources requises impliquent 2 (M+1) + 2 M + ... + 2 (K+2) additions pour les structures $FR_{2K}$, 2 x 2K additions pour la FFT et l'IFFT à $2^K$ points et $2^K$ - 1 additions pour la partie FIR.

Les ressources requises pour mettre en oeuvre un tel calcul impliquent aussi (M+4) + (M+3) + ... + (K+5) multiplications pour les structures $FR_k$, 2 x K/2 multiplications pour la FFT et l'IFFT à $2^K$ points et $2^K$ multiplications pour la partie FIR.

Cela donne au total, pour $N = 2^M$ :

$$\begin{cases} N_{ADD} = 2^K + 4K - 1 + 2 \sum_{m=K+2}^{M+1} m = 2^K - 1 + 4K + (M-K)(M+K+3) \\ N_{MUL} = 2^K + K + \sum_{m=K+5}^{M+4} m = = 2^K + K + \dfrac{(M-K)(M+K+9)}{2} \end{cases}$$

Les ressources requises impliquent aussi M - K + 2 additions correspondant à l'additionneur final de sorte que la mise en oeuvre de la figure 11 impose les ressources suivantes :

$$\begin{cases} N_{ADD} = 2^K - 1 + 12M + 4(M-K)(M+K+3) + (M-K+1) \\ N_{MUL} = 2^K + 3M + \dfrac{3(M-K)(M+K+7)}{2} \end{cases}$$

De telles valeurs sont à comparer aux valeurs requises par une réalisation avec un filtre classique selon l'état de la technique.

$$\begin{cases} N_{ADD} = 2^M - 1 \\ N_{MUL} = 2^M \end{cases}$$

Cela permet d'obtenir le tableau de comparaisons suivants :

| M | Nombres d'additions impliquées dans le cas : | | Nombres de multiplications impliquées dans le cas | |
|---|---|---|---|---|
| | figure 11 | l'état de la technique | figure 11 | l'état de la technique |
| 4 | 6 | 15 | 25 | 16 |
| 5 | 67 | 31 | 52 | 32 |
| 6 | 136 | 63 | 82 | 64 |
| 7 | 213 | 127 | 115 | 126 |
| 8 | 298 | 255 | 151 | 256 |
| 9 | 391 | 511 | 190 | 512 |
| 10 | 492 | 1023 | 232 | 1024 |
| 11 | 601 | 2047 | 277 | 2048 |
| 12 | 718 | 4095 | 325 | 4096 |
| 13 | 843 | 8191 | 376 | 8192 |
| 14 | 978 | 16383 | 430 | 16384 |
| 15 | 1117 | 32767 | 487 | 32768 |
| 16 | 1266 | 65535 | 547 | 65536 |

Il est à noter qu'un bon compromis entre ADD et MUL se trouve pour K = 6. Il est à constater que, si on code donc les 64 premiers coefficients en FIR classique, cette technique est avantageuse en termes de ressources de calcul par rapport au FIR classique dès que la taille de la réponse dépasse 64 (128 et plus) pour les multiplieurs et 256 (512 et plus) pour les additionneurs. Cependant, la différence est tolérable entre 128 et 512 pour les additionneurs qui ne sont pas de gros opérateurs en comparaison des multiplieurs.

Le filtre 18 proposé présente ainsi une latence nulle.

Le filtre 18 repose dans les deux cas sur une structure en poupée russe dans laquelle chaque poupée russe est un étage de calcul servant à la FFT pour un étage et la IFFT pour un autre étage.

Le filtre 18 utilise ainsi la latence avantageusement pour réaliser un retard assurant à la fin une latence nulle pour le filtrage total réalisé.

De ce principe, il peut être dérivé un procédé de filtrage d'un signal d'entrée numérique échantillonné à une fréquence d'échantillonnage pour obtenir un signal filtré, le procédé comportant au moins une étape de fourniture, une étape de transmission, une étape d'obtention d'un premier signal de sortie, une étape d'obtention d'un deuxième signal de sortie et une étape d'application.

Lors de l'étape de fourniture, il est fourni un signal d'entrée.

Lors de l'étape de transmission, il est transmis le signal d'entrée sur deux voies de traitement.

Pour obtenir le premier signal de sortie, l'étape d'obtention correspondante comprend la mise en oeuvre de premières opérations sur la première voie de traitement, les premières opérations comportant au moins l'application une transformée de Fourier discrète à $M/2^p$ points sur un signal issu du signal d'entrée, l'entier p étant supérieur ou égal à 1.

Une telle étape d'obtention correspond à l'utilisation d'une latence de valeur $M/2^p$ pour générer un retard permettant d'utiliser les calculs de FFT ou d'IFFT pour un autre étage de manière synchronisée.

Pour obtenir le deuxième signal de sortie, l'étape d'obtention correspondante comprend la mise en oeuvre de deuxièmes opérations sur la deuxième voie de traitement, les deuxièmes opérations comportant au moins l'application d'un décalage de $M/2$ points à un signal issu du signal d'entrée puis l'application d'une transformée de Fourier discrète à $M/2^p$ points sur le signal décalé.

Une telle étape d'obtention est interprétable comme l'utilisation d'une latence de valeur $M/2^p$ pour générer un retard permettant d'utiliser les calculs de FFT ou d'IFFT pour un autre étage de manière synchronisée.

Lors de l'étape d'application, il est appliqué une transformée de Fourier discrète à $M/2^p$ points sur le premier signal pour obtenir M points de spectre du premier signal, M étant un nombre entier strictement supérieur à 2, l'étape d'application étant mise en oeuvre par l'addition des résultats de deux voies de traitement.

De préférence, le procédé est mis en oeuvre, et notamment au moins de l'étape d'application, pour une pluralité de valeurs de p.

En particulier, entre chaque itération, l'entier p augmente par incrément de 1.

Selon un exemple, p est inférieur ou égal l'entier $p_0$, l'entier $p_0$ étant un entier vérifiant $M/2^{p_0} = 1$.

Selon un exemple, les premières opérations comportent un premier traitement du signal d'entrée pour obtenir un signal traité, le signal sur lequel la transformée de Fourier discrète à $M/2^p$ points sur un signal issu du signal d'entrée est le signal traité, chaque point de spectre du signal traité correspondant aux indices pairs d'une analyse spectrale à $2* M/2^p$ points du signal traité et étant repéré de manière bijective par un indice k, k étant un nombre pair compris entre 0 et $2* M/2^p$ -1. Les premières opérations comprennent, en outre, un deuxième traitement des points de spectre du signal traité pour obtenir des premiers points sélectionnés, une application de la transformée de Fourier discrète inverse à $M/2^p$ points sur les premiers points sélectionnés pour obtenir un premier signal, et un troisième traitement du premier signal pour obtenir un premier signal de sortie.

Selon un autre exemple ou en complément, les deuxièmes opérations comportant un premier traitement du signal d'entrée pour obtenir un signal traité, le signal sur lequel la transformée de Fourier discrète à $M/2^p$ points sur un signal issu du signal d'entrée est le signal traité, chaque point de spectre du signal traité correspondant aux indices impairs d'une analyse spectrale à $2* M/2^p$ points du signal traité et étant repéré de manière bijective par un indice k, k étant un nombre pair compris entre 0 et $2* M/2^p$ -1. Les deuxièmes opérations comprennent, en outre, un deuxième traitement des points de spectre du signal traité pour obtenir des deuxièmes points sélectionnés, une application de la transformée de Fourier discrète inverse à M points sur les deuxièmes points sélectionnés pour obtenir un deuxième signal, et un troisième traitement du deuxième signal pour obtenir un deuxième signal de sortie.

Les procédés de filtrage précités permettent dans chacun des cas d'obtenir une latence nulle.

En résumé, lorsque les longueurs des réponses temporelles d'un filtre de type FIR sont très grandes, la réalisation du filtrage devient problématique voire impossible compte tenu du très grand nombre de ressources que cela implique, surtout si le FIR doit être programmable.

Pour contourner ce problème, une telle opération est effectuée dans le spectre. Pour cela, on passe du domaine des temps à celui des fréquences par transformation de Fourier, l'opération de filtrage devenant alors multiplicative, puis on revient dans le domaine des temps par transformation de Fourier inverse.

Ce faisant, pour une longueur réponse temporelle égale à N, ces architectures introduisent par principe un retard égal à 2N périodes d'échantillonnage par rapport à celui de la réponse du FIR théorique. De telles structures seront appelées structure de base.

Un des filtres proposés est dérivé des structures à FFT et IFFT de base. De façon schématique, la structure proposée consiste à décomposer la réponse temporelle du FIR en tronçons de tailles 2, 2, 4, 8, 16, ..., $2^{N-1}$ dont la somme est égale à $2^N$. Dans cette décomposition, les tronçons les plus longs correspondent aux domaines temporels les plus retardés de la réponse temporelle.

Chaque tronçon est assuré par une sous-structure de latence égale à la durée de la réponse que la sous-structure assure si bien que sa latence de réalisation introduit naturellement le retard associé à sa position dans la réponse.

Les sous-structures sont réalisées par la combinaison de deux structures de base de taille moitié et décalées de leur demi-latence ; cela permet de réduire de moitié la latence par rapport aux structures de base.

Les architectures proposées permettent de résoudre le problème intrinsèque de latence des structures de base ; grâce à une forte optimisation qui exploite diverses décompositions de la FFT et de l'IFFT, elle conserve la caractéristique des architectures initiales, à base de FFT et d'IFFT, de ne requérir que peu de ressources de calcul (malgré une certaine inflation par rapport au ces architectures initiales) tout en retrouvant la caractéristique des architectures classiques de FIR de ne pas présenter de latences.

Grâce à la réduction des ressources que les architectures précitées permettent, l'architecture proposée permet l'utilisation de FIR de grandes tailles dans toute application requérant des latences de réalisation les plus faibles possible.

**Revendications**

1. Procédé de simplification d'un filtre numérique de signal échantillonné, le signal échantillonné étant un signal obtenu par un système, le système étant un radar, un système de communication, un système de contre-mesures ou un système de détection, le système comportant une antenne et une chaîne de traitement, l'antenne recevant un signal d'entrée et la chaîne de traitement échantillonnant le signal pour obtenir le signal échantillonné, le procédé comportant au moins une étape de:

   - fourniture d'un filtre comprenant :

      - des premières voies propres à obtenir un premier signal de sortie par mise en oeuvre de premières opérations, et
      - des deuxièmes voies propres à obtenir un deuxième signal de sortie par mise en oeuvre de deuxièmes opérations, et
      - une unité de recombinaison des signaux obtenus en sortie des premières voies et des deuxièmes voies,

   les premières opérations et les deuxièmes opérations comportant au moins une succession d'opérations non-stationnaires discrètes et d'opérations stationnaires, la succession portant sur des opérations communes aux premières et deuxièmes opérations, et
   - pour obtenir un premier filtre intermédiaire, rassemblement des voies comportant des opérations non-stationnaires discrètes portant sur le même signal, les premières voies comportant les opérations non-stationnaires portant sur un premier signal et les deuxièmes voies comportant les opérations non-stationnaires portant sur un deuxième signal,
   - pour obtenir un deuxième filtre intermédiaire, sur chacune des premières voies et deuxièmes voies, commutation des opérations stationnaires avec les opérations non-stationnaires, pour éliminer les opérations non-stationnaires redondantes, et
   - construction du filtre correspondant au dernier filtre intermédiaire obtenu.

2. Procédé de simplification selon la revendication 1, dans lequel les opérations non-stationnaires comportent deux opérations réciproques l'une de l'autre.

3. Procédé de simplification selon la revendication 1 ou 2, dans lequel les deux signaux de l'étape de rassemblement forment un signal complet.

4. Procédé de simplification selon l'une quelconque des revendications 1 à 3, dans lequel le nombre de points de chaque signal est identique.

5. Procédé de simplification selon l'une quelconque des revendications 1 à 4, dans lequel les opérations non-stationnaires sont choisies dans un groupe constitué des transformées de Fourier discrètes, des transformées de Fourier inverse discrètes et des translations de fréquence.

6. Procédé de simplification selon l'une quelconque des revendications 1 à 5, dans lequel les opérations stationnaires sont des opérations discrètes dans un groupe constitué d'un filtrage réalisé de manière multiplicative en fréquence, une sommation, un retard et une différence.

7. Système, le système étant un radar, un système de communication, un système de contre-mesures ou un système de détection, le système comportant une antenne et une chaîne de traitement, l'antenne recevant un signal d'entrée et la chaîne de traitement échantillonnant le signal pour obtenir le signal échantillonné, la chaîne de traitement comprenant un filtre obtenu après mise en oeuvre du procédé de simplification selon l'une quelconque des revendications 1 à 6.

**Patentansprüche**

1. Verfahren zum Vereinfachen eines digitalen Filters für ein abgetastetes Signal, wobei das abgetastete Signal ein Signal ist, das von einem System erlangt wird, wobei das System ein Radar, ein Kommunikationssystem, ein Gegenmaßnahmensystem oder ein Detektionssystem ist, wobei das System eine Antenne und eine Verarbeitungskette umfasst, wobei die Antenne ein Eingangssignal empfängt und die Verarbeitungskette das Signal abtastet, um das abgetastete Signal zu erlangen, wobei das Verfahren mindestens einen folgenden Schritt umfasst:

   - Bereitstellen eines Filters, umfassend:

      - erste Kanäle, die geeignet sind, um durch Durchführen erster Vorgänge ein erstes Ausgangssignal zu erlangen, und
      - zweite Kanäle, die geeignet sind, um durch Durchführen zweiter Vorgänge ein zweites Ausgangssignal zu erlangen, und
      - eine Rekombinationseinheit der erlangten Signale, die am Ausgang der ersten Kanäle und der zweiten Kanäle erlangt werden,

   die ersten Vorgänge und die zweiten Vorgänge umfassend mindestens eine Abfolge von separaten nicht-stationären Vorgänge und stationären Vorgänge, wobei sich die Abfolge sich auf Vorgänge bezieht, die den ersten und zweiten Vorgängen gemeinsam sind, und
   - zum Erlangen eines ersten Zwischenfilters, Zusammenfassen von Kanälen, die separate nicht-stationäre Vorgänge umfassen, die sich auf das gleiche Signal beziehen, wobei die ersten Kanäle die nicht-stationären Vorgänge umfassen, die sich auf ein erstes Signal beziehen, und die zweiten Kanäle die nicht-stationären Vorgänge umfassen, die sich auf ein zweites Signal beziehen,
   - zum Erlangen eines zweiten Zwischenfilters, bei jedem der ersten und der zweiten Kanäle, Umschalten der stationären Vorgänge mit den nicht-stationären Vorgängen, um redundante nicht-stationäre Vorgänge zu eliminieren, und
   - Konstruktion des Filters, der dem zuletzt erlangten Zwischenfilter entspricht.

2. Vereinfachungsverfahren nach Anspruch 1, wobei die nicht-stationären Vorgänge zwei Vorgänge umfassen, die zueinander reziprok sind.

3. Vereinfachungsverfahren nach Anspruch 1 oder 2, wobei die zwei Signale des Zusammenfassungsschritts ein komplettes Signal bilden.

4. Vereinfachungsverfahren nach einem der Ansprüche 1 bis 3, wobei die Anzahl an Punkten von jedem Signal gleich ist.

5. Vereinfachungsverfahren nach einem der Ansprüche 1 bis 4, wobei die nicht-stationären Vorgänge ausgewählt sind aus einer Gruppe, bestehend aus separaten Fourier-Transformationen, separaten inversen Fourier-Transformationen und Frequenztranslationen.

6. Vereinfachungsverfahren nach einem der Ansprüche 1 bis 5, wobei die stationären Vorgänge separate Vorgänge in einer Gruppe sind, die aus einer frequenzmultiplikativ durchgeführten Filterung, einer Summation, einer Verzögerung und einer Differenz besteht.

7. System, wobei das System ein Radar, ein Kommunikationssystem, ein Gegenmaßnahmensystem oder ein Detektionssystem ist, wobei das System eine Antenne und eine Verarbeitungskette umfasst, wobei die Antenne ein Eingangssignal empfängt und die Verarbeitungskette das Signal abtastet, um das abgetastete Signal zu erlangen, die Verarbeitungskette umfassend einen Filter, der nach Durchführen des Vereinfachungsverfahrens nach einem der Ansprüche 1 bis 6 erlangt wird.

**Claims**

1. Method for simplifying a sampled signal digital filter, the sampled signal being a signal obtained by a system, the system being a radar, a communication system, a countermeasures system or a detecting system, the system comprising an antenna and a processing chain, the antenna receiving an input signal and the processing chain sampling the signal, to obtain a sampled signal, the method including at least one step for:

   - providing a filter comprising:

      - first channels able to obtain a first output signal by carrying out first operations, and
      - second channels able to obtain a second output signal by carrying out second operations, and
      - a unit for recombination of the signals obtained at the output of the first channels and the second channels,

   the first operations and the second operations including at least one series of discrete nonstationary operations and stationary operations, the series pertaining to operations shared by the first and second operations, and
   - in order to obtain a first intermediate filter, gathering channels including discrete nonstationary operations relating to the same signal, the first channels including the nonstationary operations relating to a first signal and the second channels including the nonstationary operations relating to a second signal,
   - in order to obtain a second intermediate filter, on each of the first channels and second channels, commutative stationary operations with the nonstationary operations, in order to eliminate the redundant nonstationary operations, and
   - building the filter corresponding to the last obtained intermediate filter.

2. Method for simplifying according to claim 1, wherein the nonstationary operations include two mutually reciprocal operations.

3. Method for simplifying according to claim 1 or 2, wherein the nonstationary two signals of the gathering step form a complete signal.

4. Method for simplifying according to any one claims 1 to 3, wherein the number of points of each signal is identical.

5. Method for simplifying according to any one claims 1 to 4, wherein the nonstationary operations are chosen from a group made up of discrete Fourier transforms, inverse discrete Fourier transforms and frequency translations.

6. Method for simplifying according to any one claims 1 to 5, wherein the stationary operations are discrete operations in a group made up of filtering done in a frequency multiplicative manner, an addition, a delay and a difference.

7. A system, the system being a radar, a communication system, a countermeasures system or a detecting system, the system comprising an antenna and a processing chain, the antenna receiving an input signal and the processing chain sampling the signal, to obtain a sampled signal, the processing chain comprising a filter obtained after carrying out a method for simplifying according to any one of claims 1 to 6.

**FIG.1**

FIG.2

EP 3 809 287 B1

FIG.3

FIG.4

EP 3 809 287 B1

FIG.5

$$\underline{FIG.6}$$

FIG.7

FIG.8

<u>FIG.9</u>

$$\underline{\text{FIG.10}}$$

FIG.11

34

# FIG.12

FIG.13

FIG.14